(19) 

**Europäisches Patentamt**
**European Patent Office**
**Office européen des brevets**

(11) **EP 4 704 249 A1**

(12) **EUROPEAN PATENT APPLICATION**
published in accordance with Art. 153(4) EPC

(43) Date of publication:
04.03.2026 Bulletin 2026/10

(21) Application number: 24796909.0

(22) Date of filing: 18.04.2024

(51) International Patent Classification (IPC):
$H01Q\ 1/22^{(2006.01)}$    $B32B\ 7/025^{(2019.01)}$
$B32B\ 17/00^{(2006.01)}$    $H05K\ 3/00^{(2006.01)}$

(52) Cooperative Patent Classification (CPC):
B32B 7/025; B32B 17/00; H01Q 1/22; H05K 3/00

(86) International application number:
PCT/JP2024/015382

(87) International publication number:
WO 2024/225156 (31.10.2024 Gazette 2024/44)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 28.04.2023 JP 2023074385

(71) Applicant: AGC INC.
Chiyoda-ku,
Tokyo 1008405 (JP)

(72) Inventors:
• **HIRAMATSU, Tetsuya**
**Tokyo 100-8405 (JP)**
• **IKUMA, Yoshiyuki**
**Tokyo 100-8405 (JP)**
• **SONODA, Ryuta**
**Tokyo 100-8405 (JP)**

(74) Representative: **Müller-Boré & Partner**
**Patentanwälte PartG mbB**
**Friedenheimer Brücke 21**
**80639 München (DE)**

(54) **RADIO WAVE TRANSMISSION BODY, MATCHING BODY, AND ANTENNA DEVICE**

(57)     Provided is an electromagnetic wave transparent body, in which reflection of electromagnetic waves can be suppressed.

An electromagnetic wave transparent body according to one embodiment satisfies the following formulas: $(n_1-0.3)\times(C_0/(4\times f\times\sqrt(\varepsilon_{r1}))) \leq d_1 \leq (n_1+0.3)\times(C_0/(4\times f\times\sqrt(\varepsilon_{r1})))$; $d_2 = n_2\times C_0/(4\times f\times\sqrt(\varepsilon_{r2}))$; $d_3 = n_3\times C_0/(4\times f\times\sqrt(\varepsilon_{r3}))$; $0 \leq n_2 \leq 2$; $0 < n_3 \leq 3$; $(((n_3-1)\cos\theta+(n_2-a_2)\sin\theta)/a_3)^2+((-(n_3-1)\sin\theta+(n_2-a_2)\cos\theta)/a_4)^2 \geq 1$; $(((n_3-3)\cos\theta+(n_2-a_2)\sin\theta)/a_3)^2+((-(n_3-3)\sin\theta+(n_2-a_2)\cos\theta)/a_4)^2 \geq 1$; $\theta = -38°$; $a_2 = 1$; $a_3 = 1.2$; and $a_4 = 0.6$, where $d_1$ is a total thickness of a main substrate; $d_2$ is a thickness of an intermediate layer; $d_3$ is a thickness of a matching layer; $C_0$ is a speed of electromagnetic wave in air; f is a frequency of electromagnetic wave; and $n_1$ is an even number from 2 to 20.

Fig. 1

**Description**

TECHNICAL FIELD

The present disclosure relates to an electromagnetic wave transparent body, a matching body and an antenna device.

BACKGROUND ART

Conventionally known is a technique in which an electromagnetic wave transparent body covering an antenna is used as a building finishing material to improve electromagnetic wave transmission performance (see, for example, Patent Document 1).

PRIOR ART DOCUMENTS

PATENT DOCUMENTS

Patent Document 1: JP-A-H6-196915

DISCLOSURE OF INVENTION

TECHNICAL PROBLEM

Antennas such as microstrip antennas strongly radiate electromagnetic waves in the frontward direction. However, when a main substrate (such as a window glass or glass facade etc.) having a relatively high relative permittivity is situated frontward (forward) of an antenna, electromagnetic waves are reflected at the interface of the main substrate.
The present disclosure provides an electromagnetic wave transparent body, a matching body and an antenna device, in which reflection of electromagnetic waves can be suppressed.

SOLUTION TO PROBLEM

According to a first aspect, there is provided an electromagnetic wave transparent body comprising:

a main substrate having, at a frequency f of electromagnetic wave, a relative permittivity $\varepsilon_{r1}$ of from 4 to 7 and a dielectric loss tangent of 1.4/f or less;
an intermediate layer located on a first side with respect to the main substrate and having, at the frequency f, a relative permittivity $\varepsilon_{r2}$ of from 1 to 1.5 and a dielectric loss tangent of 1.4/f or less; and
a matching layer located on the first side with respect to the intermediate layer and having, at the frequency f, a relative permittivity $\varepsilon_{r3}$ of from 0.7 times to 1.3 times a value of $\sqrt{(\varepsilon_{r1})}$ and a dielectric loss tangent of 1.4/f or less,
the electromagnetic wave transparent body satisfying the following formulas:

$$(n_1-0.3)\times(C_0/(4\times f\times\sqrt{(\varepsilon_{r1})})) \le d_1 \le (n_1+0.3)\times(C_0/(4\times f\times\sqrt{(\varepsilon_{r1})}));$$

$$d_2 = n_2\times C_0/(4\times f\times\sqrt{(\varepsilon_{r2})});$$

$$d_3 = n_3\times C_0/(4\times f\times\sqrt{(\varepsilon_{r3})});$$

$$0 \le n_2 \le 2;$$

$$0 < n_3 \le 3;$$

$$(((n_3-1)\cos\theta+(n_2-a_2)\sin\theta)/a_3)^2+((-(n_3-1)\sin\theta+(n_2-a_2)\cos\theta)/a_4)^2 \ge 1;$$

$$(((n_3-3)\cos\theta+(n_2-a_2)\sin\theta)/a_3)^2+((-(n_3-3)\sin\theta+(n_2-a_2)\cos\theta)/a_4)^2 \geq 1;$$

$$\theta = -38°;$$

$$a_2 = 1;$$

$$a_3 = 1.2;$$

and

$$a_4 = 0.6,$$

where $d_1$ is a total thickness of the main substrate; $d_2$ is a thickness of the intermediate layer; $d_3$ is a thickness of the matching layer; $C_0$ is a speed of the electromagnetic wave in air; and $n_1$ is an even number from 2 to 20.

According to a second aspect, there is provided an electromagnetic wave transparent body comprising:

a main substrate having, at a frequency f of electromagnetic wave, a relative permittivity $\varepsilon_{r1}$ of from 4 to 7 and a dielectric loss tangent of 1.4/f or less;
an intermediate layer located on a first side with respect to the main substrate and having, at the frequency f, a relative permittivity $\varepsilon_{r2}$ of from 1 to 1.5 and a dielectric loss tangent of 1.4/f or less; and
a matching layer located on the first side with respect to the intermediate layer and having, at the frequency f, a relative permittivity $\varepsilon_{r3}$ of from 0.7 times to 1.3 times a value of $\sqrt{(\varepsilon_{r1})}$ and a dielectric loss tangent of 1.4/f or less,
the electromagnetic wave transparent body satisfying the following formulas:

$$d_1 = n_1 \times C_0/(4 \times f \times \sqrt{(\varepsilon_{r1})});$$

$$d_2 = n_2 \times C_0/(4 \times f \times \sqrt{(\varepsilon_{r2})});$$

$$d_3 = n_3 \times C_0/(4 \times f \times \sqrt{(\varepsilon_{r3})});$$

$$0.5 \leq n_1 \leq 20;$$

$$0 \leq n_2 \leq 2;$$

$$0 < n_3 \leq 3;$$

$$\theta = -25°;$$

$$a_2 = 0;$$

$$a_3 = 0.8;$$

$$a_4 = 0.14;$$

and

$$(((n_3-1)\cos\theta+(n_2-a_2)\sin\theta)/a_3)^2+((-(n_3-1)\sin\theta+(n_2-a_2)\cos\theta)/a_4)^2 \leq 1;$$

or

$$(((n_3-3)\cos\theta + (n_2-a_2)\sin\theta)/a_3)^2+((-(n_3-3)\sin\theta+(n_2-a_2)\cos\theta)/a_4)^2 \le 1,$$

where $d_1$ is a total thickness of the main substrate; $d_2$ is a thickness of the intermediate layer; $d_3$ is a thickness of the matching layer; and $C_0$ is a speed of the electromagnetic wave in air.

According to a third aspect, there is provided an electromagnetic wave transparent body as recited in the first or second aspect, wherein:

the frequency f is included in a band with a fractional bandwidth of 12%; and
a transmission loss of the electromagnetic wave transparent body is 2.5 dB or less in 70% or more of the band.

According to a fourth aspect, there is provided an electromagnetic wave transparent body as recited in any one of the first to third aspects, wherein:
the main substrate is a glass plate for buildings.

According to a fifth aspect, there is provided an electromagnetic wave transparent body as recited in any one of the first to fourth aspects, wherein:
the intermediate layer comprises a gas layer or a solid layer.

According to a sixth aspect, there is provided an electromagnetic wave transparent body as recited in the fifth aspect, wherein:

the intermediate layer comprises a gas layer and a solid layer; and
the gas layer is located between the main substrate and the solid layer.

According to a seventh aspect, there is provided an electromagnetic wave transparent body as recited in the fifth or sixth aspect, wherein:
the solid layer contains a foam.

According to an eighth aspect, there is provided an electromagnetic wave transparent body as recited in any one of the first to seventh aspects, wherein:

the intermediate layer or the matching layer has a surface on a second side opposite the first side; and
a solar absorptance of the surface is 60% or lower.

According to a ninth aspect, there is provided an electromagnetic wave transparent body as recited in any one of the first to eighth aspects, further comprising:
an antenna located on the first side with respect to the matching layer.

According to a tenth aspect, there is provided an electromagnetic wave transparent body as recited in the ninth aspect, wherein:
a distance between the main substrate and the antenna is 150 mm or less.

According to an eleventh aspect, there is provided an electromagnetic wave transparent body as recited in the ninth or tenth aspect, wherein:
the matching layer has an area large enough to cover the antenna in plan view.

According to a twelfth aspect, there is provided an electromagnetic wave transparent body as recited in the eleventh aspect, wherein:
in plan view, the matching layer has a lateral size larger than or equal to $x_a$ and a vertical size larger than or equal to $y_a$ where $x_a$ is a lateral size of the antenna; and $y_a$ is a vertical size of the antenna.

According to a thirteenth aspect, there is provided an electromagnetic wave transparent body as recited in any one of the ninth to twelfth aspects, wherein:
the main substrate comprises a conductive layer having an opening at a position facing at least a part of the antenna.

According to a fourteenth aspect, there is provided a matching body installable with an intermediate layer sandwiched between a main substrate and the matching body, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching body is located on the first side with respect to the intermediate layer and has, at the frequency f, a relative permittivity $\varepsilon_{r3}$ of from 0.7 times to 1.3 times a value of $\sqrt{\varepsilon_{r1}}$ and a dielectric loss tangent of 1.4/f or less; and
the matching body satisfies the following formulas:

$$(n_1-0.3)\times(C_0/(4\times f\times\sqrt{(\varepsilon_{r1})})) \leq d_1 \leq (n_1+0.3)\times(C_0/(4\times f\times\sqrt{(\varepsilon_{r1})}));$$

$$d_2 = n_2\times C_0/(4\times f\times\sqrt{(\varepsilon_{r2})});$$

$$d_3 = n_3\times C_0/(4\times f\times\sqrt{(\varepsilon_{r3})});$$

$$0 \leq n_2 \leq 2;$$

$$0 < n_3 \leq 3;$$

$$(((n_3-1)\cos\theta+(n_2-a_2)\sin\theta)/a_3)^2+((-(n_3-1)\sin\theta+(n_2-a_2)\cos\theta)/a_4)^2 \geq 1;$$

$$(((n_3-3)\cos\theta+(n_2-a_2)\sin\theta)/a_3)^2+((-(n_3-3)\sin\theta+(n_2-a_2)\cos\theta)/a_4)^2 \geq 1;$$

$$\theta = -38°;$$

$$a_2 = 1;$$

$$a_3 = 1.2;$$

and

$$a_4=0.6,$$

where $d_1$ is a total thickness of the main substrate; $d_2$ is a thickness of the intermediate layer; $d_3$ is a thickness of the matching body; $C_0$ is a speed of the electromagnetic wave in air; and $n_1$ is an even number from 2 to 20.

According to a fifteenth aspect, there is provided a matching body installable with an intermediate layer sandwiched between a main substrate and the matching body, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching body is located on the first side with respect to the intermediate layer and has, at the frequency f, a relative permittivity $\varepsilon_{r3}$ of from 0.7 times and to 1.3 times a value of $\sqrt{(\varepsilon_{r1})}$ and a dielectric loss tangent of 1.4/f or less; and
the matching body satisfies the following formulas:

$$d_1 = n_1\times C_0/(4\times f\times\sqrt{(\varepsilon_{r1})});$$

$$d_2 = n_2\times C_0/(4\times f\times\sqrt{(\varepsilon_{r2})});$$

$$d_3 = n_3\times C_0/(4\times f\times\sqrt{(\varepsilon_{r3})});$$

$$0.5 \leq n_1 \leq 20;$$

$$0 \leq n_2 \leq 2;$$

$$0 < n_3 \leq 3;$$

$$\theta = -25°;$$

$$a_2 = 0;$$

$$a_3 = 0.8;$$

$$a_4 = 0.14;$$

and

$$(((n_3-1)\cos\theta+(n_2-a_2)\sin\theta)/a_3)^2+((-(n_3-1)\sin\theta+(n_2-a_2)\cos\theta)/a_4)^2 \leq 1;$$

or

$$(((n_3-3)\cos\theta+(n_2-a_2)\sin\theta)/a_3)^2+((-(n_3-3)\sin\theta+(n_2-a_2)\cos\theta)/a_4)^2 \leq 1,$$

where $d_1$ is a total thickness of the main substrate; $d_2$ is a thickness of the intermediate layer; $d_3$ is a thickness of the matching body; and $C_0$ is a speed of the electromagnetic wave in air.

According to a sixteenth aspect, there is provided an antenna device installable with an intermediate layer sandwiched between a main substrate and the antenna device, the antenna device comprising a matching layer and an antenna, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching layer is located on the first side with respect to the intermediate layer and has, at the frequency f, a relative permittivity $\varepsilon_{r3}$ of from 0.7 times to 1.3 times a value of $\sqrt{(\varepsilon_{r1})}$ and a dielectric loss tangent of 1.4/f or less;
the antenna is located on the first side with respect to the matching layer; and
the antenna device satisfies the following formulas:

$$(n_1-0.3)\times(C_0/(4\times f\times\sqrt{(\varepsilon_{r1})})) \leq d_1 \leq (n_1+0.3)\times(C_0/(4\times f\times\sqrt{(\varepsilon_{r1})}));$$

$$d_2 = n_2\times C_0/(4\times f\times\sqrt{(\varepsilon_{r2})});$$

$$d_3 = n_3\times C_0/(4\times f\times\sqrt{(\varepsilon_{r3})});$$

$$0 \leq n_2 \leq 2;$$

$$0 < n_3 \leq 3;$$

$$(((n_3-1)\cos\theta+(n_2-a_2)\sin\theta)/a_3)^2+((-(n_3-1)\sin\theta+(n_2-a_2)\cos\theta)/a_4)^2 \geq 1;$$

$$(((n_3-3)\cos\theta+(n_2-a_2)\sin\theta)/a_3)^2+((-(n_3-3)\sin\theta+(n_2-a_2)\cos\theta)/a_4)^2 \geq 1;$$

$$\theta = -38°;$$

$$a_2 = 1;$$

$$a_3 = 1.2;$$

and

$$a_4 = 0.6;$$

where $d_1$ is a total thickness of the main substrate; $d_2$ is a thickness of the intermediate layer; $d_3$ is a thickness of the matching layer; $C_0$ is a speed of the electromagnetic wave in air; and $n_1$ is an even number from 2 to 20.

According to a seventeenth aspect, there is provided an antenna device installable with an intermediate layer sandwiched between a main substrate and the antenna device, the antenna device comprising a matching layer and an antenna, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching layer is located on the first side with respect to the intermediate layer and has, at the frequency f, a relative permittivity $\varepsilon_{r3}$ of from 0.7 times to 1.3 times a value of $\sqrt{(\varepsilon_{r1})}$ and a dielectric loss tangent of 1.4/f or less;
the antenna is located on the first side with respect to the matching layer; and
the antenna device satisfies the following formulas:

$$d_1 = n_1 \times C_0/(4 \times f \times \sqrt{(\varepsilon_{r1})});$$

$$d_2 = n_2 \times C_0/(4 \times f \times \sqrt{(\varepsilon_{r2})});$$

$$d_3 = n_3 \times C_0/(4 \times f \times \sqrt{(\varepsilon_{r3})});$$

$$0.5 \leq n_1 \leq 20;$$

$$0 \leq n_2 \leq 2;$$

$$0 < n_3 \leq 3;$$

$$\theta = -25°;$$

$$a_2 = 0;$$

$$a_3 = 0.8;$$

$$a_4 = 0.14;$$

and

$$(((n_3-1)\cos\theta+(n_2-a_2)\sin\theta)/a_3)^2+((-(n_3-1)\sin\theta+(n_2-a_2)\cos\theta)/a_4)^2 \leq 1;$$

or

$$(((n_3-3)\cos\theta+(n_2-a_2)\sin\theta)/a_3)^2+((-(n_3-3)\sin\theta+(n_2-a_2)\cos\theta)/a_4)^2 \leq 1,$$

where $d_1$ is a total thickness of the main substrate; $d_2$ is a thickness of the intermediate layer; $d_3$ is a thickness of the matching layer; and $C_0$ is a speed of the electromagnetic wave in air.

ADVANTAGEOUS EFFECTS OF INVENTION

According to the present disclosure, it is possible to provide an electromagnetic wave transparent body, a matching body and an antenna device, in which reflection of electromagnetic waves can be suppressed.

BRIEF DESCRIPTION OF DRAWINGS

Fig. 1 is a cross-sectional view schematically illustrating a configuration example of an electromagnetic wave transparent body according to one embodiment.

Fig. 2 is a chart illustrating boundary conditions for $n_2$ and $n_3$ in conditions A.

Fig. 3 is a chart illustrating boundary conditions for $n_2$ and $n_3$ in conditions B.

Fig. 4 is a chart illustrating a plot of pairs $(n_3, n_2)$ in a two-dimensional coordinate system, at which the electromagnetic wave transparent body meets predetermined electromagnetic wave transmission performance criteria C (in the 28 GHz band) in the case where the thickness $d_1$ is set to 8 times the value of $(\lambda_{r1}/4)$.

Fig. 5 is a chart illustrating a plot of pairs $(n_3, n_2)$ in a two-dimensional coordinate system, at which the electromagnetic wave transparent body meets predetermined electromagnetic wave transmission performance criteria C (in the 28 GHz band) in the case where the thickness $d_1$ is set to 7.5 times the value of $(\lambda_{r1}/4)$.

Fig. 6 is a chart illustrating a plot of pairs $(n_3, n_2)$ in a two-dimensional coordinate system, at which the electromagnetic wave transparent body meets predetermined electromagnetic wave transmission performance criteria C (in the 28 GHz band) in the case where the thickness $d_1$ is set to 7 times the value of $(\lambda_{r1}/4)$.

Fig. 7 is a chart illustrating simulation examples for determining whether the electromagnetic wave transparent body meets predetermined electromagnetic wave transmission performance criteria C.

Fig. 8 is chart illustrating a plot of pairs $(n_3, n_2)$ in a two-dimensional coordinate system, as set in Examples each of which satisfies the conditions B and in Comparative Examples each of which does not satisfy the conditions B.

Fig. 9 is a table illustrating, for each of ex1 to ex 8, the values set for the pair $(n_3, n_2)$ and the actual thicknesses $d_2$ and $d_3$ of an intermediate layer 60 and a matching layer 70 in the case where the frequency f is 28 GHz.

Fig. 10A is a chart illustrating examples of simulations on the relationship between the thickness $d_1$ of the main substrate and the transmission loss of the electromagnetic wave transparent body in the case where electromagnetic waves are perpendicularly incident.

Fig. 10B is a chart illustrating examples of simulations on the relationship between the thickness $d_1$ of the main substrate and the transmission loss of the electromagnetic wave transparent body in the case where electromagnetic waves are perpendicularly incident.

Fig. 11A is a chart illustrating examples of simulations on the relationship between the thickness $d_1$ of the main substrate and the transmission loss of the electromagnetic wave transparent body in the case where TE waves are obliquely incident.

Fig. 11B is a chart illustrating examples of simulations on the relationship between the thickness $d_1$ of the main substrate and the transmission loss of the electromagnetic wave transparent body in the case where TE waves are obliquely incident (at an incident angle of 40°).

Fig. 12 is a chart illustrating examples of simulations on the relationship between the thickness $d_1$ of the main substrate and the transmission loss of the electromagnetic wave transparent body in ex7 (Example).

Fig. 13 is a chart illustrating examples of simulations on the relationship between the thickness $d_1$ of the main substrate and the transmission loss of the electromagnetic wave transparent body in ex8 (Example).

Fig. 14A is a chart illustrating examples of simulations on the relationship between the thickness $d_1$ of the main substrate in the form of a single plate and the transmission loss of the electromagnetic wave transparent body in the case where electromagnetic waves are perpendicularly incident.

Fig. 14B is a chart illustrating examples of simulations on the relationship between the thickness $d_1$ of the main substrate in the form of an insulated glass unit and the transmission loss of the electromagnetic wave transparent body in the case where electromagnetic waves are perpendicularly incident.

Fig. 15A is a chart illustrating examples of simulations on the relationship between the thickness $d_1$ of the main substrate in the form of an insulated glass unit and the transmission loss of the electromagnetic wave transparent body in the case where electromagnetic waves are perpendicularly incident.

Fig. 15B is a chart illustrating examples of simulations on the relationship between the thickness $d_1$ of the main substrate in the form of an insulated glass unit and the transmission loss of the electromagnetic wave transparent body in the case where electromagnetic waves are perpendicularly incident.

Fig. 16A is a chart illustrating examples of simulations on the relationship between the thickness $d_1$ of the main substrate in the form of a single plate and the transmission loss of the electromagnetic wave transparent body in the case where TE waves are obliquely incident (at an incident angle of 40°).

Fig. 16B is a chart illustrating examples of simulations on the relationship between the thickness $d_1$ of the main substrate in the form of an insulated glass unit and the transmission loss of the electromagnetic wave transparent body in the case where TE waves are obliquely incident (at an incident angle of 40°).

Fig. 17A is a chart illustrating examples of simulations on the relationship between the thickness $d_1$ of the main substrate in the form of an insulated glass unit and the transmission loss of the electromagnetic wave transparent body in the case where TE waves are obliquely incident (at an incident angle of 40°).

Fig. 17B is a chart illustrating examples of simulations on the relationship between the thickness $d_1$ of the main substrate in the form of an insulated glass unit and the transmission loss of the electromagnetic wave transparent body in the case where TE waves are obliquely incident (at an incident angle of 40°).

Fig. 18A is a chart illustrating examples of simulations on the relationship between the thickness $d_1$ of the main substrate in the form of vacuum glass and the transmission loss of the electromagnetic wave transparent body in the case where electromagnetic waves are perpendicularly incident.

Fig. 18B is a chart illustrating examples of simulations on the relationship between the thickness $d_1$ of the main substrate in the form of vacuum glass and the transmission loss of the electromagnetic wave transparent body in the case where TE waves are obliquely incident (at an incident angle of 40°).

Fig. 19 is a chart illustrating examples of simulations on the antenna gain in the case where a phased array antenna is used as the antenna.

Fig. 20 is a plan view schematically illustrating the example of the electromagnetic wave transparent body according to one embodiment.

Fig. 21 is a perspective view schematically illustrating the example of the electromagnetic wave transparent body according to one embodiment.

Fig. 22 is a schematic view illustrating a layout example of an antenna system according to one embodiment.

Fig. 23 is a plan view schematically illustrating an antenna device according to one embodiment.

Fig. 24 is a chart illustrating a plot of pairs $(n_3, n_2)$ in a two-dimensional coordinate system, at which the electromagnetic wave transparent body meets predetermined electromagnetic wave transmission performance criteria C (in the 39 GHz band) in the case where the thickness $d_1$ is set to 8 times the value of $(\lambda_{r1}/4)$.

Fig. 25 is a chart illustrating a plot of pairs $(n_3, n_2)$ in a two-dimensional coordinate system, at which the electromagnetic wave transparent body meets predetermined electromagnetic wave transmission performance criteria C (in the 39 GHz band) in the case where the thickness $d_1$ is set to 7 times the value of $(\lambda_{r1}/4)$.

Fig. 26 is a table illustrating, for each of ex9 to ex 16, the values set for the pair $(n_3, n_2)$ and the actual thicknesses $d_2$ and $d_3$ of the intermediate layer 60 and the matching layer 70 in the case where the frequency f is 4.5 GHz.

Fig. 27A is a chart illustrating examples of simulations on the relationship between the thickness $d_1$ of the main substrate and the transmission loss of the electromagnetic wave transparent body in the case where electromagnetic waves are perpendicularly incident.

Fig. 27B is a chart illustrating examples of simulations on the relationship between the thickness $d_1$ of the main substrate and the transmission loss of the electromagnetic wave transparent body in the case where electromagnetic waves are perpendicularly incident.

Fig. 28A is a chart illustrating examples of simulations on the relationship between the thickness $d_1$ of the main substrate and the transmission loss of the electromagnetic wave transparent body in the case where TE waves are obliquely incident (at an incident angle of 40°).

Fig. 28B is a chart illustrating examples of simulations on the relationship between the thickness $d_1$ of the main substrate and the transmission loss of the electromagnetic wave transparent body in the case where TE waves are obliquely incident (at an incident angle of 40°).

Fig. 29 is a chart illustrating examples of simulations on the relationship between the thickness $d_1$ of the main substrate and the transmission loss of the electromagnetic wave transparent body in ex15 (Example).

Fig. 30 is a chart illustrating examples of simulations on the relationship between the thickness $d_1$ of the main substrate and the transmission loss of the electromagnetic wave transparent body in ex16 (Example).

DESCRIPTION OF EMBODIMENTS

Hereinafter, embodiments of the present disclosure will be described below with reference to the drawings. For ease of understanding, the scales of components illustrated in the drawings may differ from the actual scales. The directional terms as used herein, such as parallel, perpendicular, orthogonal, horizontal, vertical, upper, lower, left and right, allow deviations unless the functions and effects of the embodiments are impaired. The shape of edges is not limited to be right angled and may be round in arcuate form. The term "parallel", "perpendicular" "orthogonal", "horizontal" and "vertical" may include "substantially parallel", "substantially perpendicular", "substantially orthogonal", "substantially horizontal" and "substantially vertical", respectively.

In the present specification, a three-dimensional orthogonal coordinate system constituted by three axial directions (X axis direction, Y axis direction and Z axis direction) is used, in which a width direction or lateral direction of a main substrate is defined as the X axis direction; a height direction or vertical direction of the main substrate is defined as the Y axis direction; and a thickness direction of the main substrate is defined as the Z axis direction. A direction from the lower side toward the upper side of the main substrate is defined as a +Y axis direction; and a direction opposite the +Y direction is defined as a -Y axis direction. A direction from indoors to outdoors is defined as a +Z axis direction; and a direction opposite the +Z axis direction is defined as a -Z axis direction. In the following, the +Y axis direction may be referred to as upward; the -Y axis direction may be referred to as downward; the +Z axis direction may be referred to as the outdoor side; and the -Z axis direction may be referred to as the indoor side.

The X axis direction, the Y axis direction and the Z axis direction represent a direction parallel to the X axis, a direction parallel to the Y axis and a direction parallel to the Z axis, respectively. The X axis direction, the Y axis direction and the Z axis direction are orthogonal to one another. An XY plane, a YZ plane and a ZX plane refer to an imaginary plane parallel to the X and Y axis directions, an imaginary plane parallel to the Y and Z axis directions and an imaginary plane parallel to the Z and X axis directions, respectively.

For example, the X axis direction and the Z axis direction are substantially in parallel with a direction (horizontal direction) parallel to the horizontal plane; and the Y axis direction is substantially in parallel with a direction vertical to the horizontal plane.

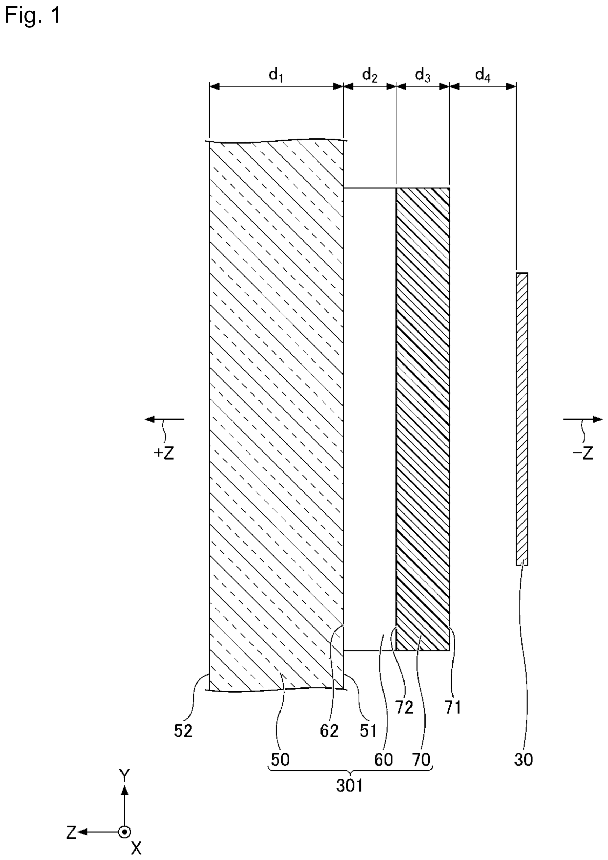

Fig. 1 is a cross-sectional view schematically illustrating an example of a layered structure of an electromagnetic wave transparent body according to one embodiment. An electromagnetic wave transparent body 301 allows electromagnetic waves to pass therethrough in the Z axis direction. Here, the +Z axis direction refers to the outdoor side with respect to the electromagnetic wave transparent body 301; and the -Z axis direction refers to the indoor side with respect to the electromagnetic wave transparent body 301. The electromagnetic wave transparent body 301 has a layered structure with a main substrate 50, an intermediate layer 60 and a matching layer 70. The electromagnetic wave transparent body 301 may further include an antenna 30 located on the first side (in Fig. 1, the -Z axis direction side) with respect to the matching layer 70 and may have a layered structure with the main substrate 50, the intermediate layer 60, the matching layer 70 and the antenna 30.

The main substrate 50 is a first dielectric layer having, at a frequency f (GHz) of electromagnetic wave incident on the electromagnetic wave transparent body 301, a relative permittivity $\varepsilon_{r1}$ of from 4 to 7 and a dielectric loss tangent (tan$\delta$) of 1.4/f or less. A typical example of the frequency f is 28 GHz and, in this case, the dielectric loss tangent is 0.05 or less. The main substrate 50 has a principal surface 51 facing the -Z axis direction (indoor side) and a principal surface 52 facing the +Z axis direction (outdoor side).

The main substrate 50 is, for example, a glass plate for buildings. Examples of the glass plate for buildings include a window glass, glass façade, and the like. The main substrate 50 may be a substrate other than the glass plate for buildings. The main substrate 50 may contain concrete, mortar, cement paste, glass, crystallized glass, ceramic tiles, stones, or the like.

The intermediate layer 60 is located on the first side (in Fig. 1, the -Z axis direction side) with respect to the main substrate 50. The intermediate layer 60 is a second dielectric layer having, at a frequency f (GHz) of electromagnetic wave incident on the electromagnetic wave transparent body 301, a relative permittivity $\varepsilon_{r2}$ of from 1 to 1.5 and a dielectric loss tangent (tan$\delta$) of 1.4/f or less. The intermediate layer 60 may include a gas layer or a solid layer, and may include both of a gas layer and a solid layer. The intermediate layer 60 may have, as a vacuum layer, a space filled with gas at a pressure lower than a standard atmospheric pressure. A fluid present in the intermediate layer 60 may be flowable between the intermediate layer 60 and the outside of the intermediate layer 60.

Specific examples of the gas used for the gas layer in the intermediate layer 60 include air, oxygen, and inert gas. The inert gas can be helium, neon, argon, krypton, xenon, radon, nitrogen, carbon dioxide, or the like.

Specific examples of the solid used for the solid layer in the intermediate layer 60 include a foam. The foam can be a foamed resin, an aerogel, or the like. As the foamed resin, a polystyrene foam, a polyethylene foam or the like may be mentioned.

In the case where the gas layer and the solid layer are provided in the intermediate layer 60, the gas layer in the intermediate layer 60 may be located between the principal surface 51 of the main substrate 50 and the gas layer in the intermediate layer 60. In such a configuration, the solid layer in the intermediate layer 60 is kept in non-contact with the solid main substrate 50, thereby avoiding an increase of mechanical load (thermal cracking, warpage, peeling) by contact of the solid layer with the main substrate 50. This effect is advantageous in the case where the thermal expansion coefficient of the solid layer in the intermediate layer 60 is different from the thermal expansion coefficient of the main substrate 50.

The matching layer 70 is located on the first side (in Fig. 1, the -Z axis direction side) with respect to the intermediate layer 60. The matching layer 70 is a third dielectric layer having, at a frequency f of electromagnetic wave incident on the electromagnetic wave transparent body 301, a relative permittivity $\varepsilon_{r3}$ of from 0.7 times to 1.3 times the value of $\sqrt{(\varepsilon_{r1})}$ and a dielectric loss tangent ($\tan\delta$) of 1.4/f or less. The matching layer 70 has a surface 71 facing the -Z axis direction (indoor side) and a surface 72 facing the +Z axis direction (outdoor side).

The matching layer 70 is an example of a matching body that adjusts an impedance mismatch between the main substrate 50 on which electromagnetic waves transmitted or received by the antenna 30 are incident and the medium present between the antenna 30 and the main substrate 50. The matching layer 70 is installed with the intermediate layer 60 sandwiched between the matching layer and the main substate 50. The matching layer 70 may be in the form of a plate- or sheet-shaped component.

The matching layer 70 may include a fluororesin, COC (cycloolefin copolymer), COP (cycloolefin polymer), PET (polyethylene terephthalate), a polycarbonate, an acrylic resin, PVB (polyvinyl butyral), EVA (ethylene-vinyl acetate), an ionomer, a polyimide, ceramic, sapphire, or a glass substrate. The matching layer 70 may be made from a composite of these materials. In the case where the matching layer 70 includes a glass substrate, the material of the glass substrate may be alkali-free glass, quartz glass, soda-lime glass, borosilicate glass, alkali borosilicate glass, aluminosilicate glass, or the like. In the case where the matching layer 70 includes a glass substrate, the glass substrate may be formed of laminated glass. The matching layer 70 may be formed by sandwiching a liquid crystal between two glass plates or resin films.

The solid layer in the intermediate layer 60 has a surface 62 on the second side (in Fig. 1, the +Z axis direction) opposite the first side. A rise in the surface temperature of the main substrate 50 can be suppressed by: in the case where the intermediate layer 60 is transparent in color, controlling the total solar absorptance for the combination of the intermediate layer 60 and the matching layer 70 to be 60% or lower; and, in the case where the intermediate layer 60 and the matching layer 70 are transparent in color, controlling the total solar absorptance for the combination of the intermediate layer 60, the matching layer 70 and the antenna 30 to be 60% or lower. From the viewpoint of suppressing a rise in the surface temperature of the main substrate 50, the solar absorptance of the surface 62 of the intermediate layer 60 or the surface 72 of the matching layer 72 is preferably 40% or lower, more preferably 25% or lower. The solar absorptance can be determined according to JIS R3106 (2019).

The antenna 30 is located on the first side (in Fig. 1, the -Z axis direction side) with respect to the matching layer 70, and is configured to transmit or receive electromagnetic waves of frequency f. Electromagnetic waves radiated from the antenna 30 pass through the electromagnetic wave transparent body 301 in the order of the matching layer 70, the intermediate layer 60 and the main substrate 50, and then, are transmitted to the outdoors. Electromagnetic waves from the outdoors pass through the electromagnetic wave transparent body 301 in the order of the main substrate 50, the intermediate layer 60 and the matching layer 70, and then, reach the antenna 30.

The antenna 30 may be in contact with the surface 71 of the matching layer 70, or may be located with a gap left between the antenna 30 and the surface 71. In other words, the distance $d_4$ between the antenna 30 and the matching layer 70 may be zero or more. The upper limit of the distance $d_4$ is not particularly limited, and may be 140 mm or less. The shorter the distance $d_4$, the less the attenuation of electromagnetic waves. Further, the shortening of the distance $d_4$ contributes to downsizing of the electromagnetic wave transparent body in the Z axis direction.

The antenna 30 is configured to transmit or receive electromagnetic waves whose frequency f is included in a desired band (frequency range) such as UHF (Ultra High Frequency) band, SHF (Super High Frequency) band or EHF (Extremely High Frequency) band. The UHF band ranges in frequency from 0.3 GHz to 3 GHz. The SHF band ranges in frequency from 3 GHz to 30 GHz. The EHF band ranges in frequency from 30 GHz to 300 GHz.

In the embodiment of Fig. 1, a total thickness of the main body 50 is denoted as $d_1$; a thickness of the intermediate layer 60 is denoted as $d_2$; a thickness of the matching layer 70 is denoted as $d_3$; a speed of electromagnetic wave in air is denoted as $C_0$; and a frequency of electromagnetic wave is denoted as f; and an even number of from 2 to 20 is denoted as $n_1$. Here, the electromagnetic wave transparent body 301 satisfies conditions A represented by the following formulas:

$$(n_1-0.3)\times(C_0/(4\times f\times\sqrt{(\varepsilon_{r1})})) \leq d_1 \leq (n_1+0.3)\times(C_0/(4\times f\times\sqrt{(\varepsilon_{r1})})) \quad \text{Formula a1;}$$

$$d_2 = n_2\times C_0/(4\times f\times\sqrt{(\varepsilon_{r2})}) \quad \text{Formula a2;}$$

$$d_3 = n_3\times C_0/(4\times f\times\sqrt{(\varepsilon_{r3})}) \quad \text{Formula a3;}$$

$$0 \leq n_2 \leq 2 \quad \text{Formula a4;}$$

$$0 < n_3 \leq 3 \quad \text{Formula a5;}$$

$$(((n_3-1)\cos\theta+(n_2-a_2)\sin\theta)/a_3)^2+((-(n_3-1)\sin\theta+(n_2-a_2)\cos\theta)/a_4)^2 \geq 1 \quad \text{Formula a6;}$$

$$(((n_3-3)\cos\theta+(n_2-a_2)\sin\theta)/a_3)^2+((-(n_3-3)\sin\theta+(n_2-a_2)\cos\theta)/a_4)^2 \geq 1 \quad \text{Formula a7;}$$

$$\theta = -38° \quad \text{Formula a8;}$$

$$a_2 = 1 \quad \text{Formula a9;}$$

$$a_3 = 1.2 \quad \text{Formula a10;}$$

and

$$a_4 = 0.6 \quad \text{Formula a11.}$$

When the electromagnetic wave transparent body 301 satisfies the conditions A, the loss of electromagnetic waves of frequency f transmitted in the electromagnetic wave transparent body 301 is reduced as shown in the later-described simulations and Examples. By such a transmission loss reduction, reflection of electromagnetic waves in the electromagnetic wave transparent body 301 is suppressed. Therefore, the electromagnetic wave transparent body 301 achieves the effect that electromagnetic waves radiated from the antenna 30 can be suppressed from being reflected at the main substrate 50.

In the case of "$n_2 = 0$" in Formula a4, the thickness $d_2$ of the intermediate layer 60 is zero. It means that the electromagnetic wave transparent body 301 has no intermediate layer 60 (that is, the surface 72 of the matching layer 70 is in contact with the principal surface 51 of the main substrate 50). The electromagnetic wave transparent body 301, even with no intermediate layer 60, achieves the effect that electromagnetic waves radiated from the antenna 30 can be suppressed from being reflected at the main substrate 50 by satisfaction of the conditions A.

Each of the conditional formulas for the conditions A will be now described below.

The term $(C_0/(4×f×\sqrt{(\varepsilon_{r1})}))$ in Formula a1 represents one-quarter of the wavelength $\lambda_{r1}$ of electromagnetic waves propagating through the main substate 50 (= $\lambda_{r1}/4$). In other words, Formula a1 indicates that the thickness $d_1$ of the main substrate 50 equals to 70% to 130% of the length of ($\lambda_{r1}/4$) multiplied by $n_1$ (= an even number greater than or equal to 2 and smaller than or equal to 20).

In view of the effect that electromagnetic waves radiated from the antenna 30 can be suppressed from being reflected at the main substrate 50, Formula a-1 is preferably Formula a1-1, more preferably Formula a1-2.

$$(n_1-0.25)×(C_0/(4×f×\sqrt{(\varepsilon_{r1})})) \leq d_1 \leq (n_1+0.25)×(C_0/(4×f×\sqrt{(\varepsilon_{r1})})) \quad \text{Formula a1-1}$$

$$(n_1-0.2)×(C_0/(4×f×\sqrt{(\varepsilon_{r1})})) \leq d_1 \leq (n_1+0.2)×(C_0/(4×f×\sqrt{(\varepsilon_{r1})})) \quad \text{Formula a1-2}$$

The term $(C_0/(4×f×\sqrt{(\varepsilon_{r2})}))$ in Formula a2 represents one-quarter of the wavelength $\lambda_{r2}$ of electromagnetic waves propagating through the intermediate layer 60 (= $\lambda_{r2}/4$). In other words, Formulas a2 and a4 indicate that the thickness $d_2$ of the intermediate layer equals to the length of ($\lambda_{r2}/4$) multiplied by $n_2$ (= a real number greater than 0 and smaller than or equal to 2).

The term $(C_0/(4×f×\sqrt{(\varepsilon_{r3})}))$ in Formula a3 represents one-quarter of the wavelength $\lambda_{r3}$ of electromagnetic waves propagating through the matching layer 70 (= $\lambda_{r3}/4$). In other words, Formulas a3 and a5 indicate that the thickness $d_3$ of the matching layer 70 equals to the length of ($\lambda_{r3}/4$) multiplied by $n_3$ (= a real number greater than 0 and smaller than or equal to 3).

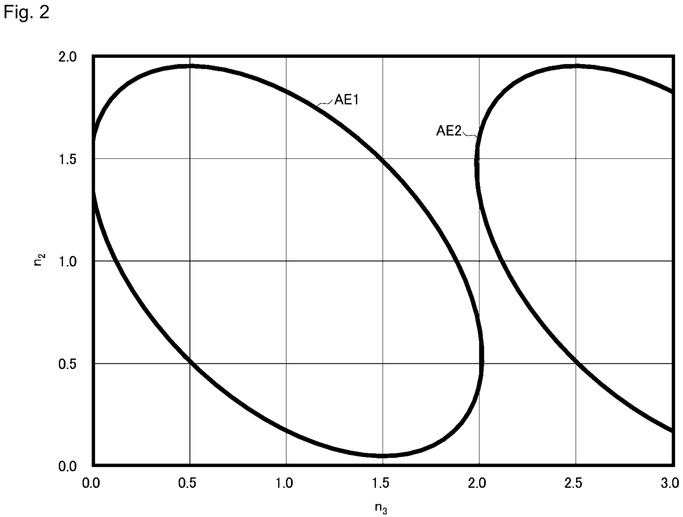

Fig. 2 is a chart illustrating the boundary conditions for $n_2$ and $n_3$ in the conditions A. The possible pair ($n_3$, $n_2$) of two numbers $n_2$ and $n_3$ can be defined by coordinates in a two-dimensional coordinate system with $n_3$ on the horizontal axis and $n_2$ on the vertical axis. The pair ($n_3$, $n_2$) satisfying Formulas a6, a8, a9, a10 and a11 exists in a region outside the elliptical AE1 defined by Formulas a6, a8, a9, a10 and a11. The pair ($n_3$, $n_2$) satisfying Formulas a7, a8, a9, a10 and a11 exists in a region outside the elliptical AE2 defined by Formulas a7, a8, a9, a10 and a11 (only a part of which is shown in Fig. 2). Therefore, the pair ($n_3$, $n_2$) satisfying Formulas a4 to a11 exists in a region outside the ellipticals AE1 and AE2 and inside the rectangle surrounded by four lines ($n_2 = 0$, $n_2 = 2$, $n_3 = 0$ and $n_3 = 3$).

Accordingly, the conditions A are satisfied by setting the thicknesses $d_2$ and $d_3$ of the intermediate layer 60 and the matching layer 70, respectively, to values derived from Formulas a2 and a3 using the pair $(n_3, n_2)$ satisfying Formulas a4 to a11 and by setting the thickness $d_1$ of the main substrate 50 to a value derived from Formula 1a. By setting the thicknesses $d_1$, $d_2$ and $d_3$ to such values that satisfy the conditions A, the electromagnetic wave transparent body 301 achieves the effect that electromagnetic waves radiated from the antenna 30 can be suppressed from being reflected at the main substrate 50.

In the embodiment of Fig. 1, the electromagnetic wave transparent body 301 may alternatively be configured to satisfy conditions B represented by the following formulas:

$$d_1 = n_1 \times C_0/(4 \times f \times \sqrt{(\varepsilon_{r1})}) \quad \text{Formula b1;}$$

$$d_2 = n_2 \times C_0/(4 \times f \times \sqrt{(\varepsilon_{r2})}) \quad \text{Formula b2;}$$

$$d_3 = n_3 \times C_0/(4 \times f \times \sqrt{(\varepsilon_{r3})}) \quad \text{Formula b3;}$$

$$0.5 \leq n_1 \leq 20 \quad \text{Formula b4;}$$

$$0 \leq n_2 \leq 2 \quad \text{Formula b5;}$$

$$0 < n_3 \leq 3 \quad \text{Formula b6;}$$

$$\theta = -25° \quad \text{Formula b9;}$$

$$a_2 = 0 \quad \text{Formula b10;}$$

$$a_3 = 0.8 \quad \text{Formula b11;}$$

$$a_4 = 0.14 \quad \text{Formula b12;}$$

and

$$(((n_3-1)\cos\theta + (n_2-a_2)\sin\theta)/a_3)^2 + ((-(n_3-1)\sin\theta + (n_2-a_2)\cos\theta)/a_4)^2 \leq 1 \quad \text{Formula b7;}$$

or

$$(((n_3-3)\cos\theta + (n_2-a_2)\sin\theta)/a_3)^2 + ((-(n_3-3)\sin\theta + (n_2-a_2)\cos\theta)/a_4)^2 \leq 1 \quad \text{Formula b8.}$$

When the electromagnetic wave transparent body 301 satisfies the conditions B, the loss of electromagnetic waves of frequency f transmitted in the electromagnetic wave transparent body 301 is reduced as shown in the later-described simulations and Examples. By satisfaction of the conditions B, the electromagnetic wave transmission body 301 achieves the effect that electromagnetic waves radiated from the antenna 30 can be suppressed from being reflected at the main substrate 50, as in the case where the electromagnetic wave transparent body satisfies the conditions A.

In the case of "$n_2 = 0$" in Formula b5, the thickness $d_2$ of the intermediate layer 60 is zero. It means that the electromagnetic wave transparent body 301 has no intermediate layer 60 (that is, the surface 72 of the matching layer 70 is in contact with the principal surface 51 of the main substrate 50). The electromagnetic wave transparent body 301, even with no intermediate layer 60, achieves the effect that electromagnetic waves radiated from the antenna 30 can be suppressed from being reflected at the main substrate 50 by satisfaction of the conditions B.

Each of the conditional formulas for the conditions B will be now described below.

Formulas b1 and b4 indicate that the thickness $d_1$ of the main substrate 50 equals to the length of $(\lambda_{r1}/4)$ multiplied by $n_1$ (= a real number greater than or equal to 0.5 and smaller than or equal to 20). Formulas b2 and b5 indicate that the thickness $d_2$ of the intermediate layer 60 equals to the length of $(\lambda_{r2}/4)$ multiplied by $n_2$ (= a real number greater than 0 and smaller than or equal to 2). Formulas b3 and b6 indicate that the thickness $d_3$ of the matching layer 70 equals to the length of

($\lambda_{r3}/4$) multiplied by $n_3$ (= a real number greater than 0 and smaller than or equal to 3).

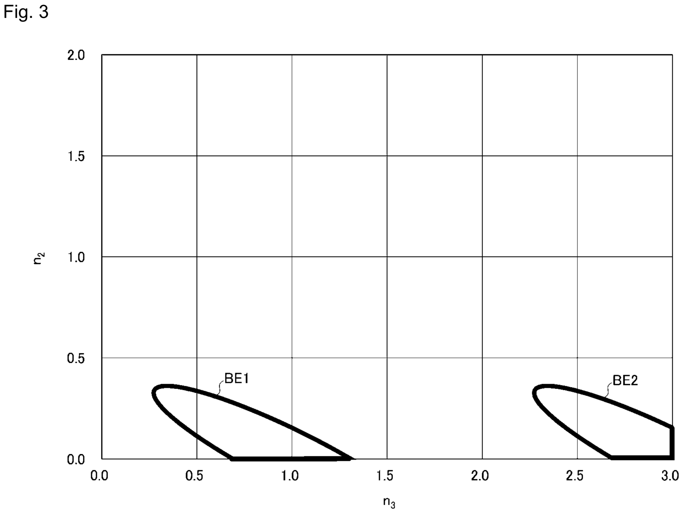

Fig. 3 is a chart illustrating the boundary conditions for $n_2$ and $n_3$ in the conditions B. The pair ($n_3$, $n_2$) satisfying Formulas b7, b9, b10, b11 and b12 exists in a region inside the elliptical BE1 defined by Formulas b7, b9, b10, b11 and b12 (only a part of which is shown in Fig. 3). The pair ($n_3$, $n_2$) satisfying Formulas b8, b9, b10, b11 and b12 exists in a region inside the elliptical BE2 defined by Formulas b8, b9, b10, b11 and b12 (only a part of which is shown in Fig. 3). Therefore, the pair ($n_3$, $n_2$) satisfying Formulas b5 to b12 exists in a region surrounded by the elliptical BE1 and a straight line ($n_2 = 0$) or in a region surrounded by the elliptical BE2 and two straight lines ($n_2 = 0$, $n_3 = 3$).

Accordingly, the conditions B are satisfied by setting the thicknesses $d_2$ and $d_3$ of the intermediate layer 60 and the matching layer 70, respectively, to values derived from Formulas b2 and b3 using the pair ($n_3$, $n_2$) satisfying Formulas b5 to b12 and by setting the thickness $d_1$ of the main substrate 50 to a value derived from Formula b1 using $n_1$ satisfying Formula b4. By setting the thicknesses $d_1$, $d_2$ and $d_3$ to such values that satisfy the conditions B, the electromagnetic wave transparent body 301 achieves the effect that electromagnetic waves radiated from the antenna 30 can be suppressed from being reflected at the main substrate 50.

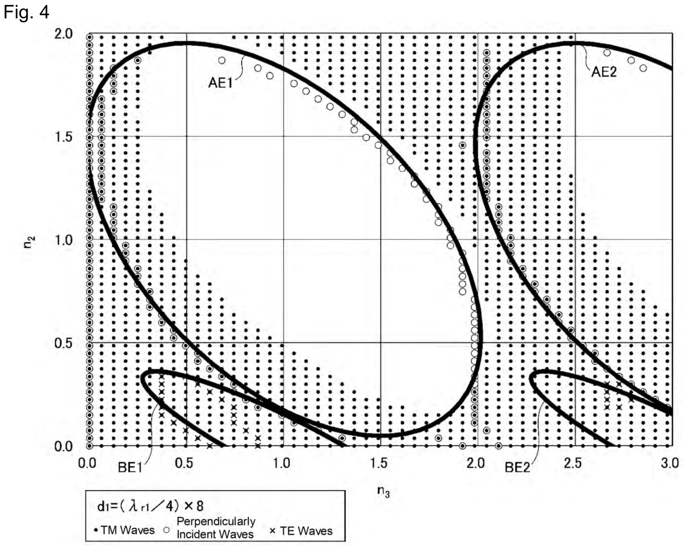

In the following, the relationship between satisfaction of the conditions A or B and suppression of reflection (reduction of transmission loss) will be described with reference to simulation examples of Figs. 4 to 7.

Figs. 4, 5 and 6 are charts showing plots of the pairs ($n_3$, $n_2$) in two-dimensional coordinate systems, at which the electromagnetic wave transparent body meets predetermined electromagnetic wave transmission performance criteria C. In the legend on each figure, "TM waves", "perpendicularly incident waves" and "TE waves" respectively refer to the case where TM waves are incident obliquely on the matching layer 70 at an incident angle $\alpha$ of 40°, the case where electromagnetic waves are incident perpendicularly on the matching layer 70 an incident angle $\alpha$ of 0° and the case where TE waves are incident obliquely on the matching layer 70 at an incident angle $\alpha$ of 40°. Although the above descriptions assume transmission from the antenna 30, but the same applies to reception.

TM (Transverse Magnetic) waves are electromagnetic waves where the magnetic field is orthogonal to the plane of incidence. TM waves correspond to horizontally polarized waves. TE (Transverse Electric) waves are electromagnetic waves where the electric field is orthogonal to the plane of incidence. TE waves correspond to vertically polarized waves. In this example, the plane of incidence is set as a ZX plane (see Fig. 1).

It is herein defined that an electromagnetic wave transparent body meets electromagnetic wave transmission performance criteria C when the transmission loss of the electromagnetic wave transparent body is 2.5 dB or less in 70% or more of a predetermined band including a frequency f. For example, frequencies of 26.5 GHz to 29.5 GHz (n257) are allocated as the 28 GHz band to 5th generation mobile communication systems in Japan. Frequencies of 37.0 GHz to 40.0 GHz (n260) are allocated to 5th generation mobile communication systems in the United States. The predetermined band including the frequency f may be thus defined as a band with a fractional bandwidth of 12% with reference to the bands allocated to the actual communication systems.

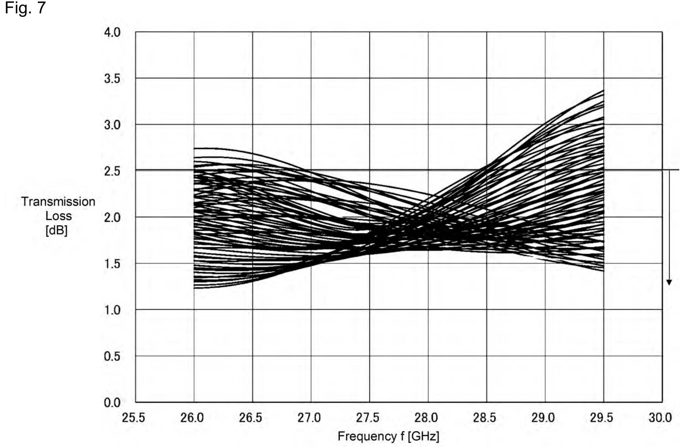

Fig. 7 is a chart illustrating simulation examples for, at the time when the pairs ($n_3$, $n_2$) at which the electromagnetic wave transparent body meets the predetermined electromagnetic wave transmission performance criteria C are plotted in a two-dimensional coordinate system, determining whether the electromagnetic wave transparent body meets the predetermined electromagnetic wave transmission performance criteria C.

The simulation conditions of Fig. 7 are set as follows.

Band used: 28 GHz band (26.0 GHz to 29.5 GHz)
Frequency f: 28.0 GHz (the center frequency or its vicinity in the band used)
Direction of incidence of electromagnetic waves: perpendicular incidence
$n_1$: 7 (an example of the odd number)
Relative permittivity $\varepsilon_{r1}$ of main substrate 50: 6.8
Dielectric loss tangent (tan$\delta$) of main substrate 50: 0.015
Thickness $d_1$ of main substrate 50: 7.2 mm (= 7 times the value of ($\lambda_{r1}/4$))
Relative permittivity $\varepsilon_{r3}$ of matching layer 70: 2.8
Dielectric loss tangent (tan$\delta$) of matching layer 70: 0.007
Intermediate layer 60: air layer

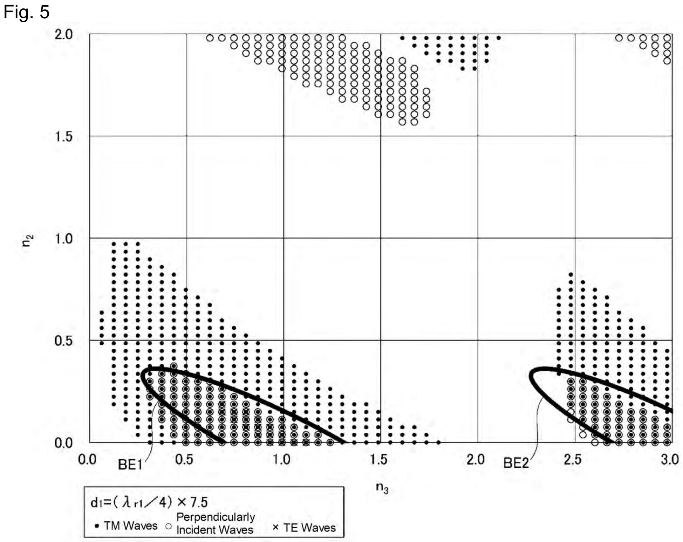

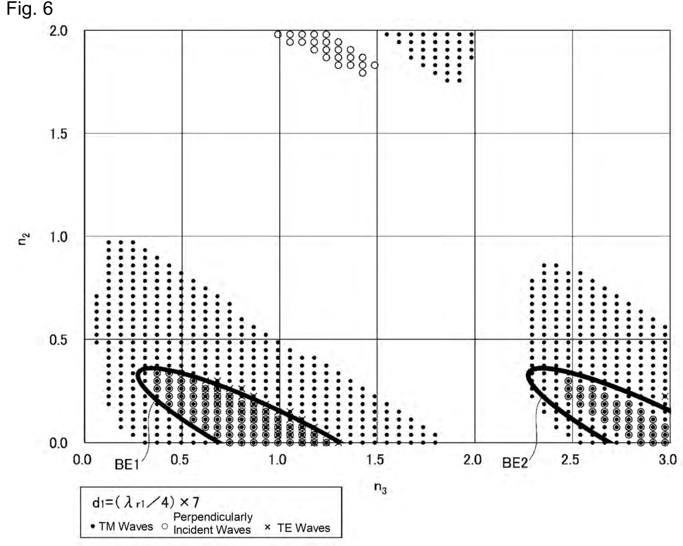

Each waveform shown in Fig. 7 represents a change in transmission loss, for each pair of the thicknesses of the intermediate layer 60 and the matching layer 70 (that is, each pair ($n_3$, $n_2$) of two possible numbers $n_2$ and $n_3$), in the 28 GHz band. In the case of Fig. 7 ($d_1$ = 7 times the value of ($\lambda_{r1}/4$)), the scatter plot of Fig. 6 can be obtained by plotting, in a two-dimensional coordinate system, the pairs ($n_3$, $n_2$) at which the transmission loss becomes 2.5 dB or less in 70% or more of the 26.0 GHz to 29.5 GHz band used. The scatter plots of Figs. 4 and 5 can be obtained by the same method.

Fig. 4 is a chart illustrating a plot of the pairs ($n_3$, $n_2$) in a two-dimensional coordinate system, at which the electromagnetic wave transparent body 301 meets the predetermined electromagnetic wave transmission performance criteria C in the case where the thickness $d_1$ of the main substrate 50 is set to 8 times the value of ($\lambda_{r1}/4$). In Fig. 4, among the

pairs ($n_3$, $n_2$) at which the electromagnetic wave transparent body 301 meets the electromagnetic wave transmission performance criteria C in the case of "perpendicularly incident waves" and "TE waves", only the pairs on the outer peripheries are plotted for the sake of clarity. In fact, the pairs ($n_3$, $n_2$) at which the electromagnetic wave transparent body 301 meets the electromagnetic wave transmission performance criteria C in the case of "perpendicularly incident waves" and "TE waves" also exist in the regions inside the outer peripheries. In Fig. 4, also shown are the favorable conditions (ellipticals AE1, AE2, BE1 and BE2) for the pairs ($n_3$, $n_2$). The simulations illustrated in Fig. 4 assume satisfaction of the conditions A and B because $n_1$ is set to 8 (even number).

The simulation conditions of Fig. 4 are the same as the simulation conditions of Fig. 7, except that $n_1$ is set to 8 (an example of the even number).

According to Fig. 4, the electromagnetic wave transparent body 301 satisfying the conditions A shows electromagnetic wave transmission performance with a transmission loss of 2.5 dB or less in 70% or more of the 28 GHz band for any incident wave mode of "TM waves", "perpendicularly incident waves" and "TE waves" in the case where the thickness $d_1$ of the main substrate 50 is 8 times the value of ($\lambda_{r1}/4$). According to Fig. 4, the electromagnetic wave transparent body 301 satisfying the conditions B shows electromagnetic wave transmission performance with a transmission loss of 2.5 dB or less in 70% or more of the 28 GHz band for any incident wave mode of "TM waves", "perpendicularly incident waves" and "TE waves" in the case where the thickness $d_1$ of the main substrate 50 is 8 times the value of ($\lambda_{r1}/4$).

Fig. 5 is a chart illustrating a plot of the pairs ($n_3$, $n_2$) in a two-dimensional coordinate system, at which the electromagnetic wave transparent body 301 meets the predetermined electromagnetic wave transmission performance criteria C in the case where the thickness $d_1$ of the main substrate 50 is set to 7.5 times the value of ($\lambda_{r1}/4$). In Fig. 5, the favorable conditions (ellipticals BE1 and BE2) for the pairs ($n_3$, $n_2$) are also shown. The simulations illustrated in Fig. 5 assume satisfaction of the conditions B because $n_1$ is set to 7.5.

The simulation conditions of Fig. 5 are the same as the simulation conditions of Fig. 7, except that $n_1$ is set to 7.5 (an example of the intermediate value between the even number and the odd number).

According to Fig. 5, the electromagnetic wave transparent body 301 satisfying the conditions B shows electromagnetic wave transmission performance with a transmission loss of 2.5 dB or less in 70% or more of the 28 GHz band for any incident wave mode of "TM waves", "perpendicularly incident waves" and "TE waves" in the case where the thickness $d_1$ of the main substrate 50 is set to 7.5 times the value of ($\lambda_{r1}/4$).

Fig. 6 is a chart illustrating a plot of the pairs ($n_3$, $n_2$) in a two-dimensional coordinate system, at which the electromagnetic wave transparent body 301 meets the predetermined electromagnetic wave transmission performance criteria C in the case where the thickness $d_1$ of the main substrate 50 is set to 7 times the value of ($\lambda_{r1}/4$). In Fig. 6, the favorable conditions (ellipticals BE1 and BE2) for the pairs ($n_3$, $n_2$) are also shown. The simulations illustrated in Fig. 6 assume satisfaction of the conditions B because $n_1$ is set to 7.

The simulation conditions of Fig. 6 are the same as the simulation conditions of Fig. 7, except that $n_1$ is set to 7 (an example of the odd number).

According to Fig. 6, the electromagnetic wave transparent body 301 satisfying the conditions B shows electromagnetic wave transmission performance with a transmission loss of 2.5 dB or less in 70% or more of the 28 GHz for any incident wave mode of "TM waves", "perpendicularly incident waves" and "TE waves" in the case where the thickness $d_1$ of the main substrate 50 is set to 7 times the value of ($\lambda_{r1}/4$).

Therefore, the satisfaction of the conditions A or B brings about electromagnetic wave transmission performance with a transmission loss of 2.5 dB or less in 70% or more of the 28 GHz band, as shown in the simulation examples of Figs. 4, 5 and 6, whereby reflection in the electromagnetic wave transparent body 301 is suppressed.

Here, Figs. 4, 5 and 6 illustrate the case where the band used, including the frequency f, is the 28 GHz band. Even in the other band used, the electromagnetic wave transparent body 301 achieves electromagnetic wave transmission performance with a reduced transmission loss by satisfaction of the conditions A or B whereby reflection in the electromagnetic wave transparent body 301 is suppressed. This reflection suppression effect of the electromagnetic wave transparent body 301 is significantly enhanced in the case where the frequency f is 3 GHz or higher (in particular, 10 GHz or higher).

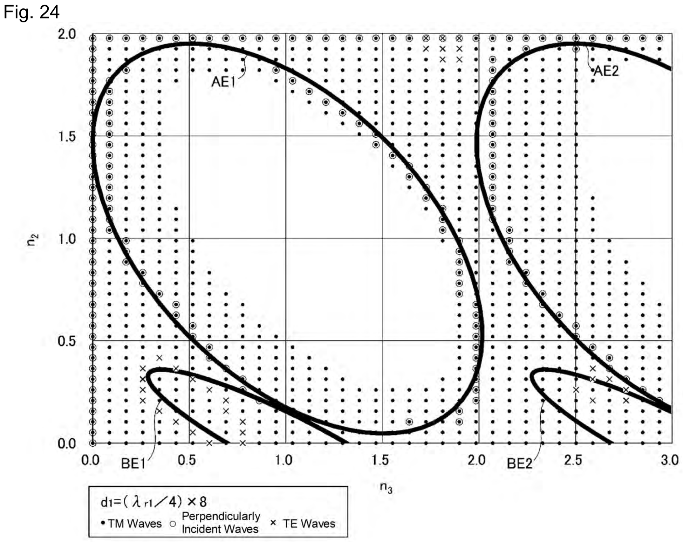

Fig. 24 is a chart illustrating a plot of the pairs ($n_3$, $n_2$) in a two-dimensional coordinate system, at which the electromagnetic wave transparent body meets the predetermined electromagnetic transmission performance criteria C (in the 39 GHz band) in the case where the thickness $d_1$ is set to 8 times the value of ($\lambda_{r1}/4$). As in Fig. 4 (the 28 GHz band), among the pairs ($n_3$, $n_2$) at which the electromagnetic wave transparent body 301 meets the electromagnetic wave transmission performance criteria C in the case of "perpendicularly incident waves" and "TE waves", only the pairs on the outer peripheries are shown in Fig. 24 for the sake of clarity. In fact, the pairs ($n_3$, $n_2$) at which the electromagnetic wave transparent body 301 meets the electromagnetic wave transmission performance criteria C in the case of "perpendicularly incident waves" and "TE waves" also exist in the regions inside the outer peripheries. The simulation conditions of Fig. 24 are the same as those of Fig. 4.

According to Fig. 24, the electromagnetic wave transparent body 301 satisfying the conditions A shows electromagnetic wave transmission performance with a transmission loss of 2.5 dB or less in 70% or more of the 39 GHz band for any incident wave mode of "TM waves", "perpendicularly incident waves" and "TE waves" in the case where the thickness $d_1$ of the main substrate 50 is set to 8 times the value of $(\lambda_{r1}/4)$. According to Fig. 24, the electromagnetic wave transparent body 301 satisfying the conditions B shows electromagnetic wave transmission performance with a transmission loss of 2.5 dB or less in 70% or more of the 39 GHz band for any incident wave mode of "TM waves", "perpendicularly incident waves" and "TE waves" in the case where the thickness $d_1$ of the main substrate 50 is set to 8 times the value of $(\lambda_{r1}/4)$.

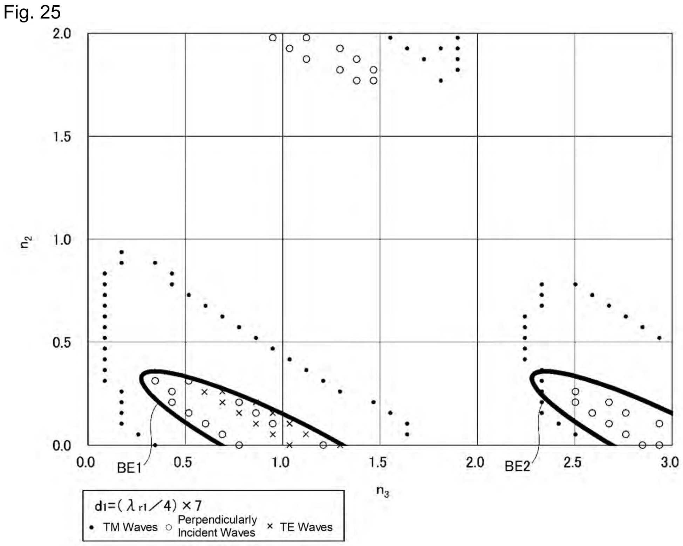

Fig. 25 is a chart illustrating a plot of the pairs $(n_3, n_2)$ in a two-dimensional coordinate system, at which the electromagnetic wave transparent body 301 meets the predetermined electromagnetic transmission performance criteria C (in the 39 GHz band) in the case where the thickness $d_1$ is set to 7 times the value of $(\lambda_{r1}/4)$. As in Fig. 6 (the 28 GHz band), among the pairs $(n_3, n_2)$ at which the electromagnetic wave transparent body 301 meets the electromagnetic wave transmission performance criteria C in the case of "TM waves", "perpendicularly incident waves" and "TE waves", only the pairs on the outer peripheries are shown in Fig. 25 for the sake of clarity. In fact, the pairs $(n_3, n_2)$ at which the electromagnetic wave transparent body 301 meets the electromagnetic wave transmission performance criteria C in the case of "TM waves", "perpendicularly incident waves" and "TE waves" also exist in the regions inside the outer peripheries. The simulation conditions of Fig. 25 are the same as those of Fig. 6.

According to Fig. 25, the electromagnetic wave transparent body 301 satisfying the conditions B shows electromagnetic wave transmission performance with a transmission loss of 2.5 dB or less in 70% or more of the 39 GHz band for any incident wave mode of "TM waves", "perpendicularly incident waves" and "TE waves" in the case where the thickness $d_1$ of the main substrate 50 is set to 7 times the value of $(\lambda_{r1}/4)$.

Even when the other parameters $(n_1, n_2, n_3, \varepsilon_{r1}, \varepsilon_{r2}, \varepsilon_{r3})$ in the conditions A or B are set to values other than those illustrated in the above simulation conditions, the electromagnetic wave transparent body 301 shows electromagnetic wave transmission performance with a reduced transmission loss by satisfaction of the conditions A or B whereby reflection in the electromagnetic wave transparent body 301 is suppressed. When one of the conditions for the matching layer 70, "a relative permittivity $\varepsilon_{r3}$ of from 0.7 times to 1.3 times the value of $\sqrt{(\varepsilon_{r1})}$", is not satisfied (for example, when $\varepsilon_{r1}$ is 6.8 and $\varepsilon_{r3}$ is 1.5), there is no pair $(n_3, n_2)$ at which the electromagnetic wave transparent body meets the above electromagnetic wave transmission performance criteria C.

Next, simulation results of Examples satisfying the conditions B and Comparative Examples not satisfying the conditions B will be described below.

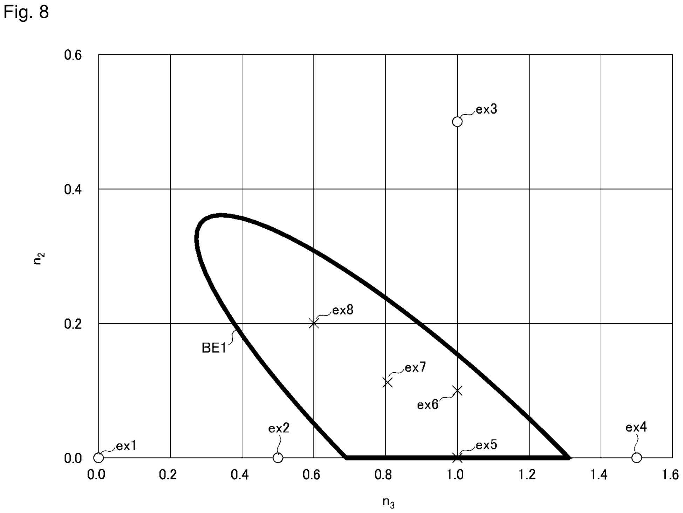

Fig. 8 is a chart illustrating a plot of the pairs $(n_3, n_2)$ in a two-dimensional coordinate system, as set in Examples each of which satisfies the conditions B and in Comparative Examples each of which does not satisfy the conditions B. Ex. 1, Ex. 2, Ex. 3 and Ex. 4 are abbreviated as ex1, ex2, ex3 and ex4, respectively. In the figure, ex1, ex2, ex3 and ex4 respectively indicate the pairs $(n_3, n_2)$ in Comparative Examples not satisfying the conditions B. Ex. 5, Ex. 6, Ex. 7 and Ex. 8 are abbreviated as ex5, ex6, ex7 and ex8, respectively. In the figure, ex5, ex6, ex7 and ex8 respectively indicates the pairs $(n_3, n_2)$ in Examples satisfying the conditions B.

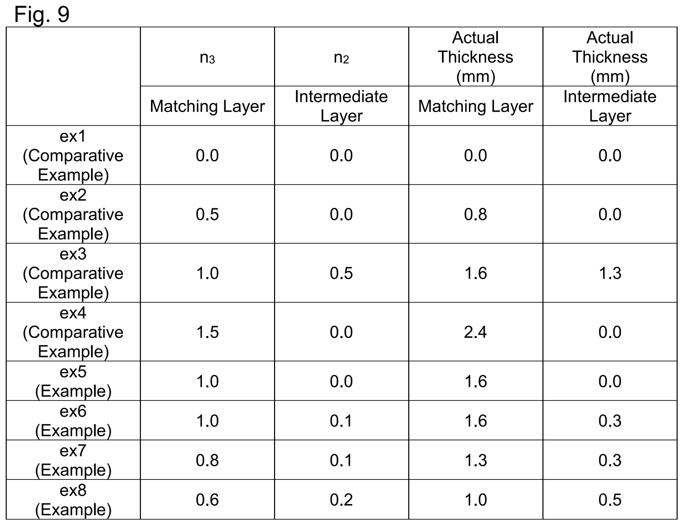

Fig. 9 is a table illustrating, for each of ex1 to ex8, the values set for the pair $(n_3, n_2)$ and the actual thicknesses $d_2$ and $d_3$ of the intermediate layer 60 and the matching layer 70 in the case where the frequency f is 28 GHz.

The thickness $d_1$ of main substrates 50 actually used in the world is set to various values. It may be difficult to specify the thickness $d_1$ of main substrates used in the already existing buildings. It is therefore desirable that the conditions A or B are applicable regardless of the value of the thickness $d_1$.

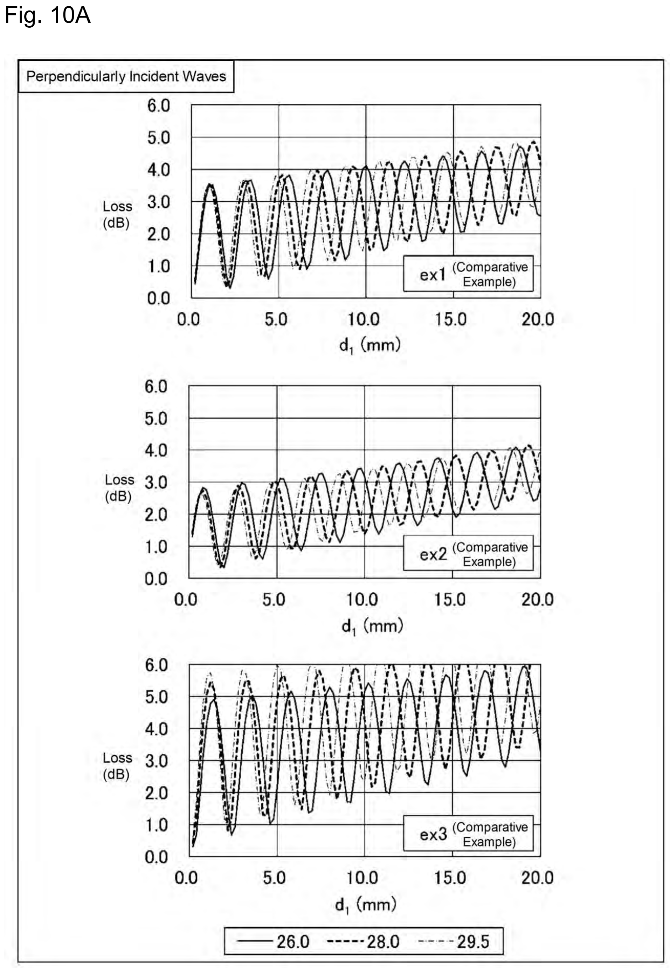

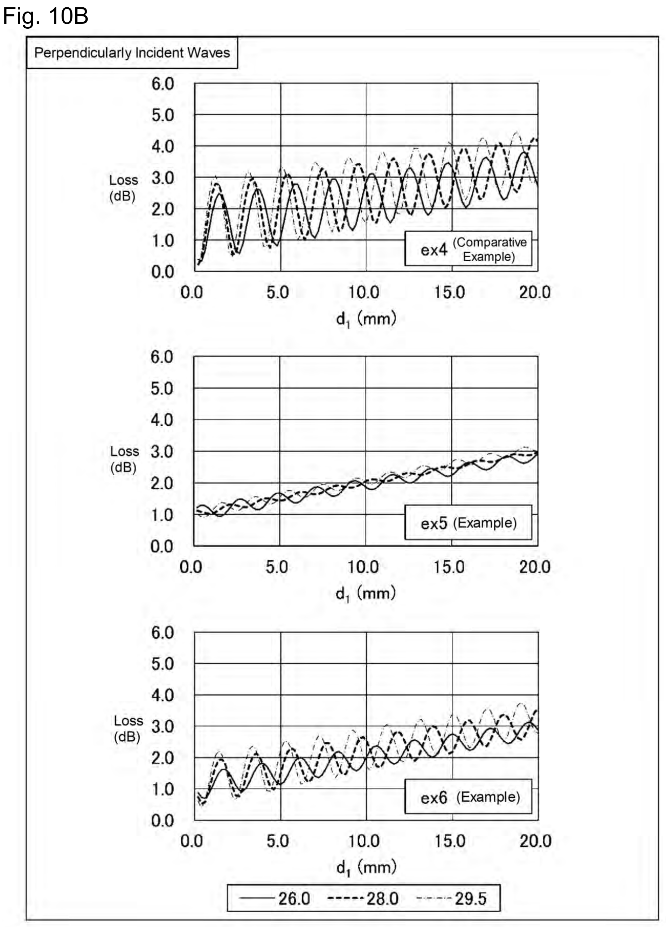

The relationship between the thickness $d_1$ of the main substrate 50 and the transmission loss of the electromagnetic wave transparent body 301 will be next described below. More specifically, examples of simulations on the relationship between the thickness $d_1$ of the main substrate 50 and the transmission loss of the electromagnetic wave transparent body 301 in each of ex1 to ex8 will be described below with reference to Figs. 10 to 18, taking as an example the case where the frequency f is in the 28 GHz band.

The simulation conditions of Figs. 10 to 18 are set as follows.

Frequency f: three types such as 26.0 GHz, 28.0 GHz and 29.5 GHz
Relative permittivity $\varepsilon_{r1}$ of main substrate 50: 6.8
Dielectric loss tangent (tan$\delta$) of main substrate 50: 0.015
Relative permittivity $\varepsilon_{r3}$ of matching layer 70: 2.8
Dielectric loss tangent (tan$\delta$) of matching layer 70: 0.007
Intermediate layer 60: air layer

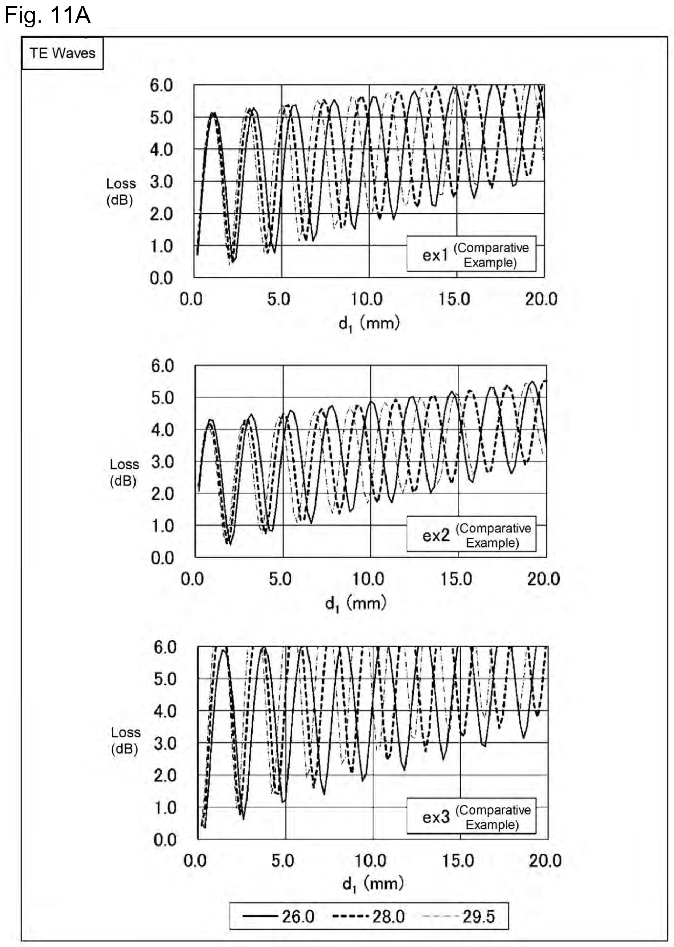

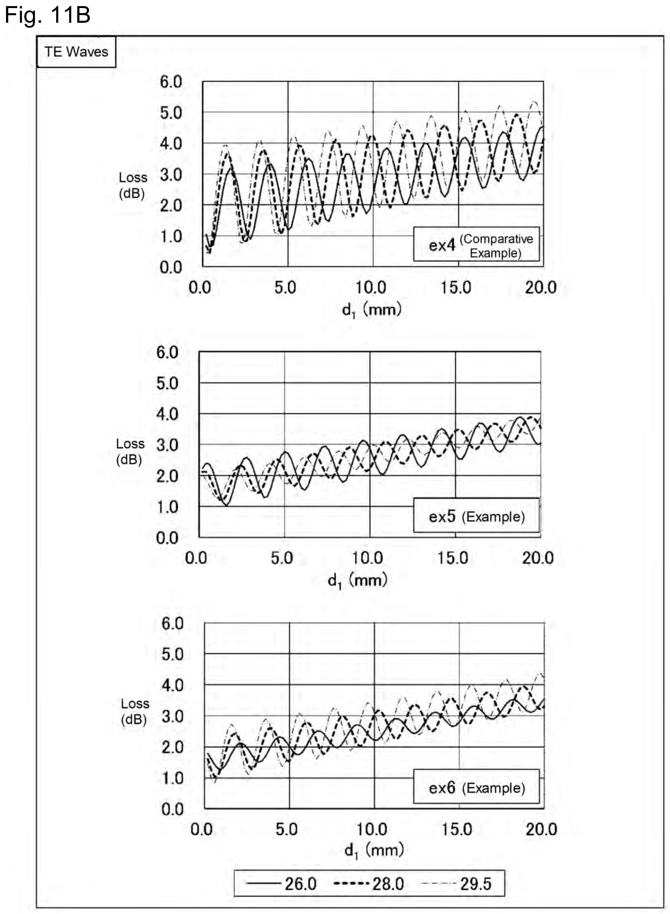

Figs. 10A and 10B are charts illustrating examples of simulations on the relationship between the thickness $d_1$ of the main substrate 50 and the transmission loss of the electromagnetic wave transparent body 301 in the case where electromagnetic waves are incident perpendicularly on the matching layer 70 at an incident angle $\alpha$ of 0°. Figs. 11A and 11B are charts illustrating examples of simulations on the relationship between the thickness $d_1$ of the main substrate 50 and the transmission loss of the electromagnetic wave transparent body 301 in the case where TE waves are incident obliquely on the matching layer 70 at an incident angle $\alpha$ of 40°.

When comparing Figs. 10A, 10B, 11A and 11B, the transmission loss is reduced in Examples satisfying the conditions B as compared to Comparative Examples not satisfying the conditions B. Further, variations in transmission loss relative to the thickness $d_1$ of the main substrate 50 are smaller in Examples satisfying the conditions B than in Comparative Examples not satisfying the conditions B, and thus, stable electromagnetic wave transmission performance is obtained in Examples.

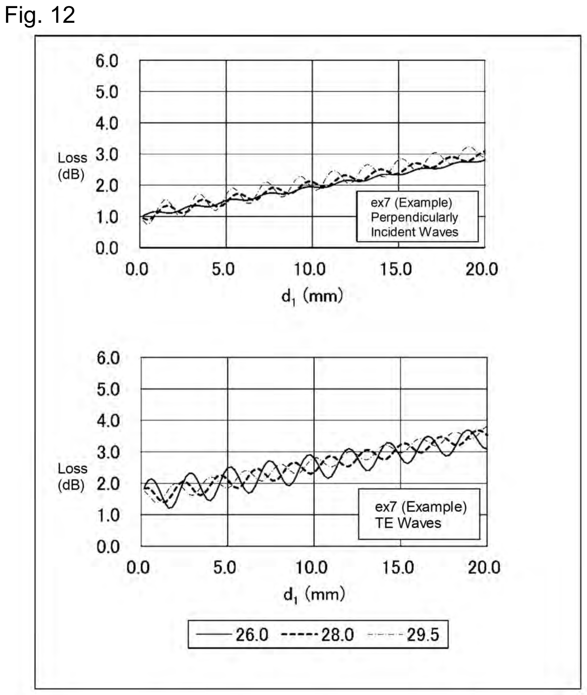

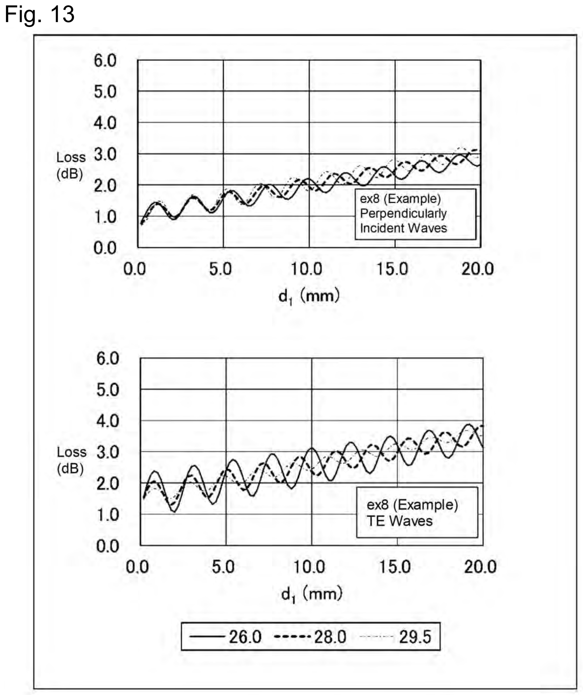

As seen from comparison of ex5 where no intermediate layer 60 is present and ex6 where the intermediate layer 60 is present in Figs. 10B and 11B, variations in transmission loss relative to the thickness $d_1$ of the main substrate 50 become large in the presence of the intermediate layer 60. When the thickness $d_3$ of the matching layer 70 is reduced by an amount of 20% to 40%, however, there can be obtained good electromagnetic wave transmission performance in which variations in transmission loss relative to the thickness $d_1$ of the main substrate 50 are suppressed (see Figs. 12 and 13).

Fig. 12 is a chart illustrating examples of simulations on the relationship between the thickness $d_1$ of the main substrate 50 and the transmission loss of the electromagnetic wave transparent body 301 in ex7 (Example). Fig. 13 is a chart illustrating examples of simulations on the relationship between the thickness $d_1$ of the main substrate 50 and the transmission loss of the electromagnetic wave transparent body 301 in ex8 (Example). In each of Figs. 12 and 13, one graph shows the simulation results in the case where electromagnetic waves are incident perpendicularly on the matching layer 70 at an incident angle $\alpha$ of 0°; and the other graph shows the simulation results in the case where TE waves are incident obliquely on the matching layer 70 at an incident angle $\alpha$ of 40°.

Variations in transmission loss relative to the thickness $d_1$ of the main substrate 50 are suppressed in ex7 (Fig. 12) and ex8 (Fig. 13) as compared to ex6 (Figs. 10B and 11B). The arrangement of the matching layer 70 in addition to the intermediate layer 60 such as air layer is significantly advantageous in reducing mechanical load (thermal cracking, warpage, peeling) in the case where the matching layer 70 differs in thermal expansion coefficient from the main substrate 50. For example, the matching layer 70 containing a resin has a higher thermal expansion coefficient than that of the main substrate 50 in the form of a glass plate.

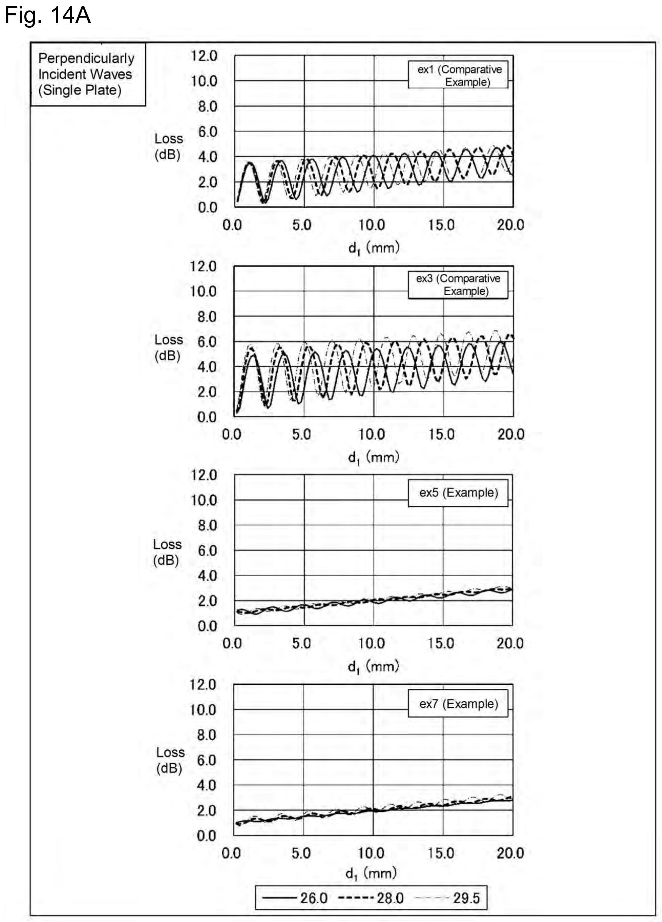

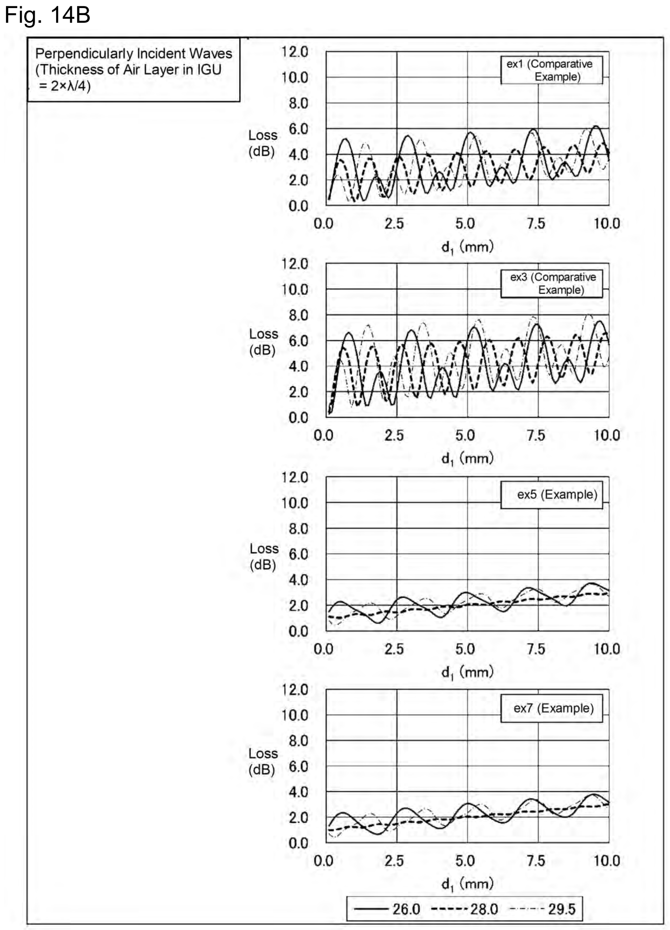

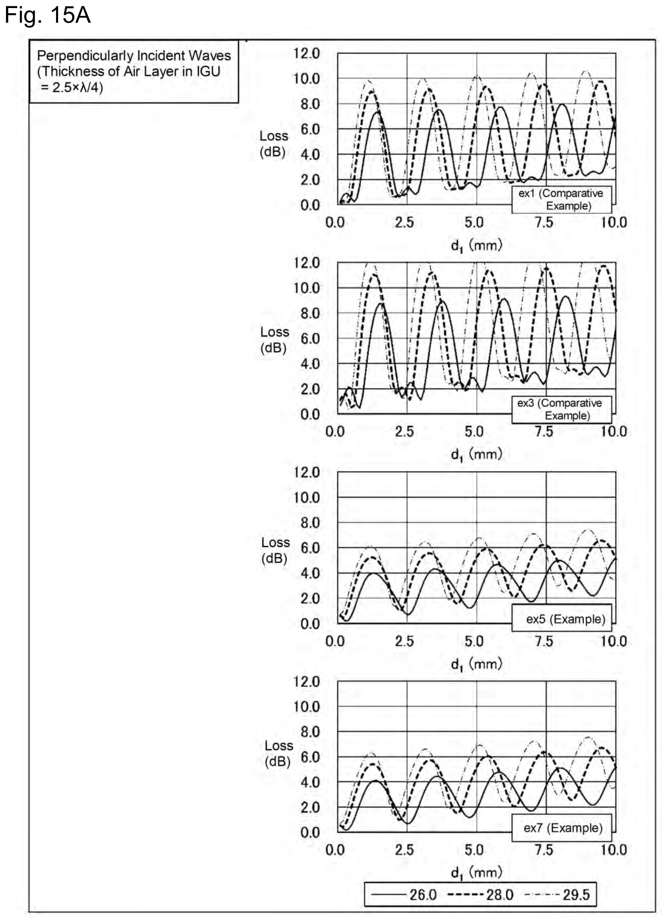

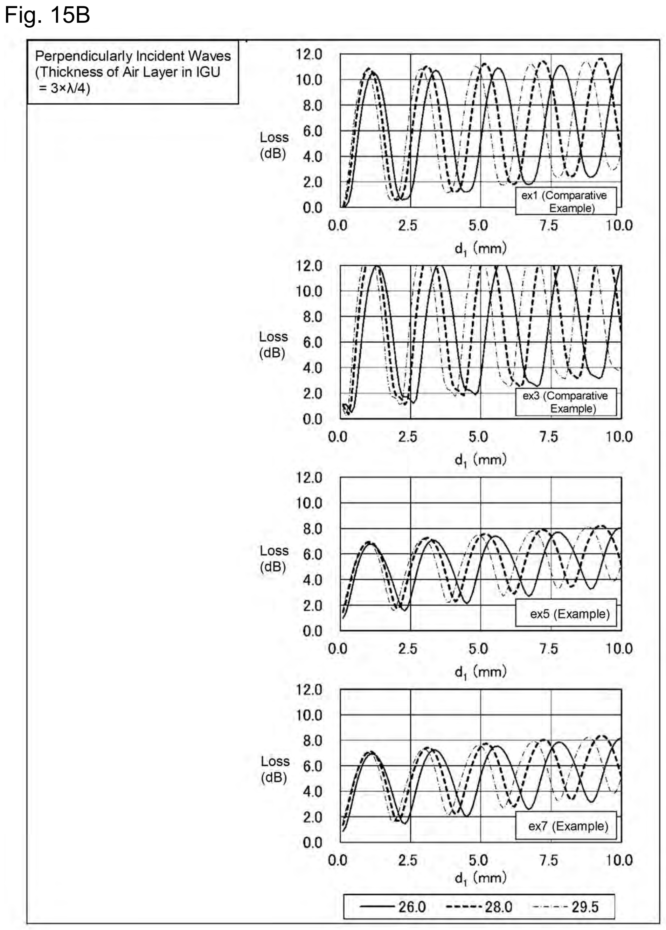

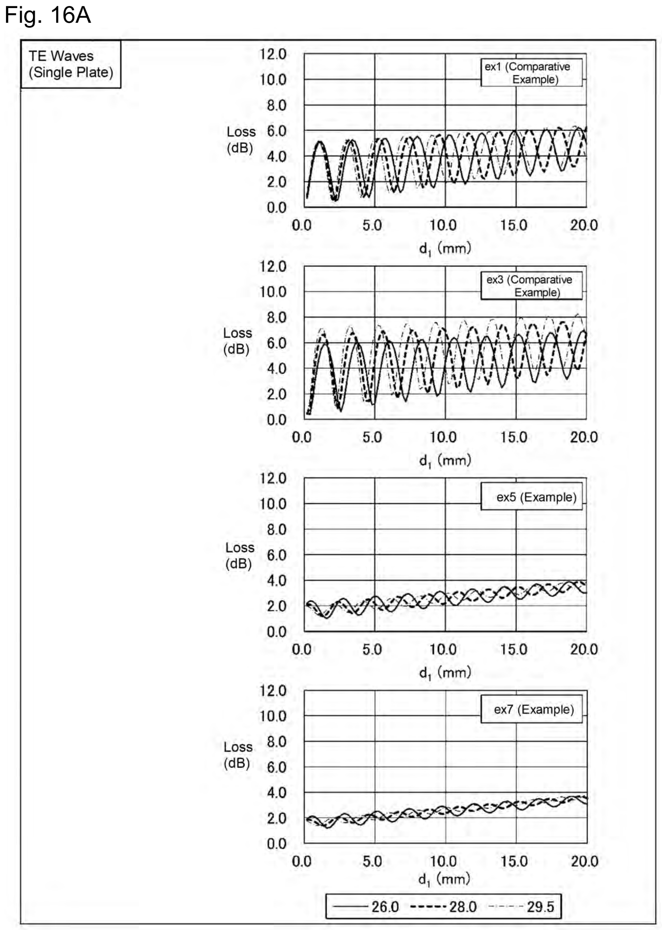

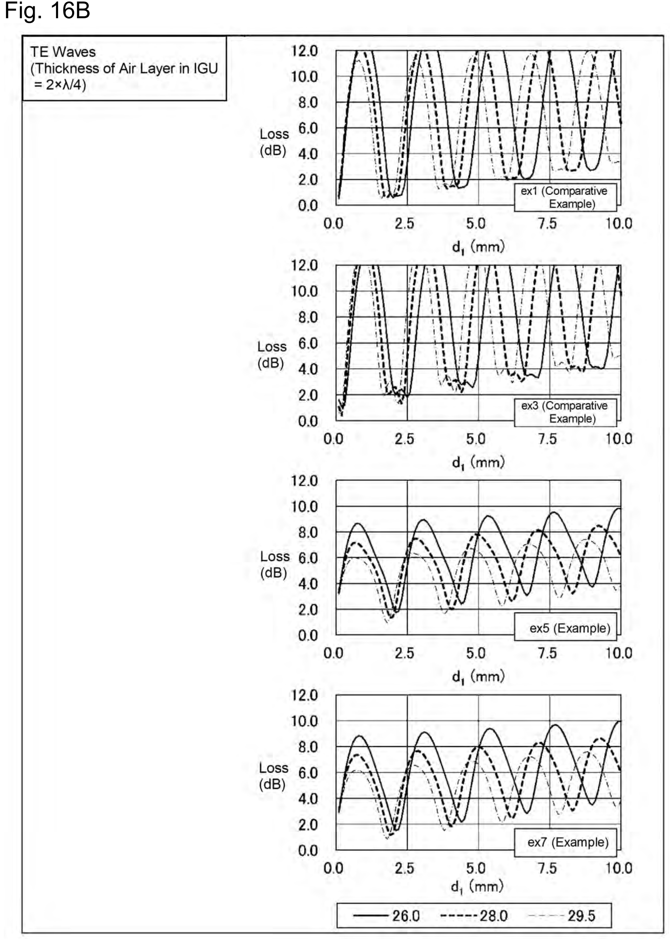

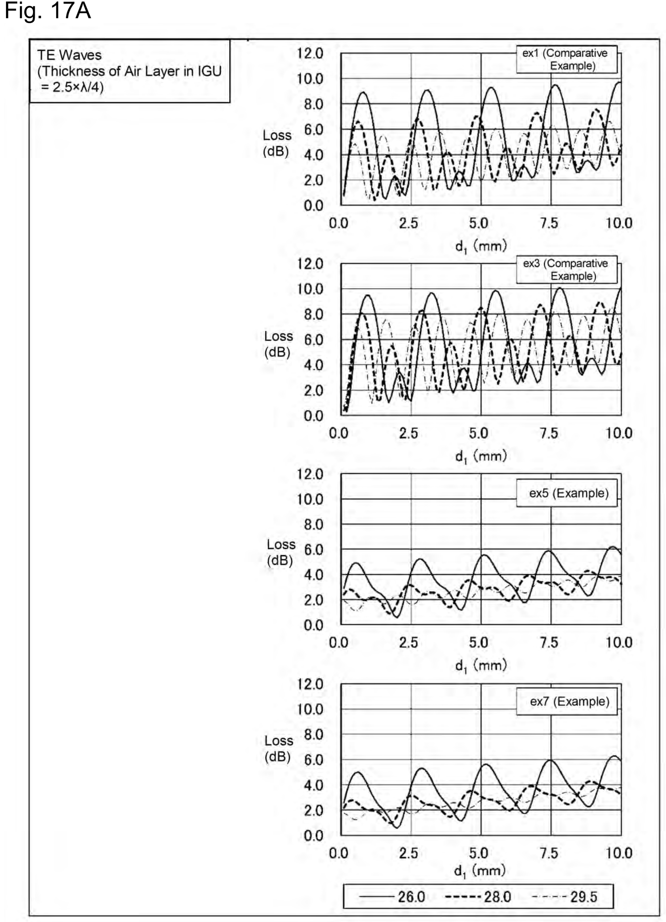

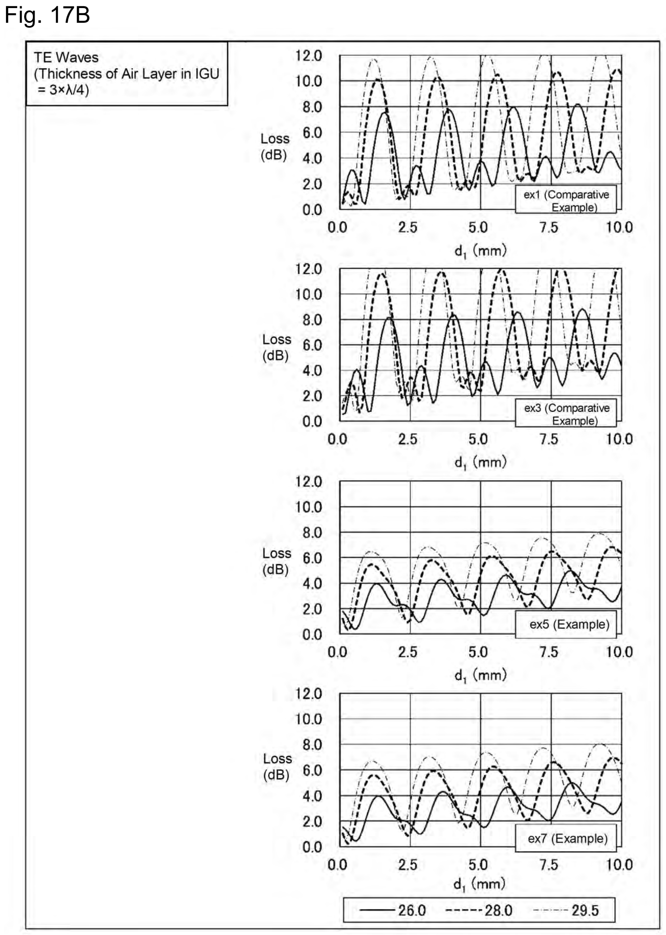

Fig. 14A is a chart illustrating examples of simulations on the relationship between the thickness $d_1$ of the main substrate 50 in the form of a single plate and the transmission loss of the electromagnetic wave transparent body 301 in the case where electromagnetic waves are incident perpendicularly on the matching layer 70 at an incident angle $\alpha$ of 0°. Figs. 14B, 15A and 15B are charts illustrating examples of simulations on the relationship between the thickness $d_1$ of the main substrate 50 in the form of an insulated glass unit (IGU) and the transmission loss of the electromagnetic wave transparent body 301 in the case where electromagnetic waves are incident perpendicularly on the matching layer 70 at an incident angle $\alpha$ of 0°. The thickness of an air layer in the insulated glass unit is $2\times\lambda/4$ (Fig. 14B), $2.5\times\lambda/4$ (Fig. 15A) or $3\times\lambda/4$ (Fig. 15B). Fig. 16A is a chart illustrating examples of simulations on the relationship between the thickness $d_1$ of the main substrate 50 in the form of a single plate and the transmission loss of the electromagnetic wave transparent body 301 in the case where TE waves are incident obliquely at an incident angle $\alpha$ of 40°. Figs. 16B, 17A and 17B are charts illustrating examples of simulations on the relationship between the thickness $d_1$ of the main substrate 50 in the form of an insulated glass unit (IGU) and the transmission loss of the electromagnetic wave transparent body 301 in the case where TE waves are incident obliquely at an incident angle $\alpha$ of 40°. The thickness of an air layer in the insulated glass unit is $2\times\lambda/4$ (Fig. 16B), $2.5\times\lambda/4$ (Fig. 17A) or $3\times\lambda/4$ (Fig. 17B).

In the simulations of Figs. 14B, 15A, 15B, 16B, 17A and 17B, for the sake of simplicity, a pair of glass plates in the IGU are considered to have the same thickness.

When the main substrate 50 is in the form of an IGU, the transmission loss of the electromagnetic wave transparent body 301 is influenced by the thickness of an air layer between a pair of glass plates in the IGU. In the case of the IGU, the behavior of electromagnetic waves passing through the electromagnetic wave transparent body 301 can be organized according to the multiplication factor for $(\lambda_{r1}/4)$, as in the case of the single plate. As typical examples of the multiplication factor, shown are three types: 2 (Figs. 14B and 16B); 2.5 (Figs. 15A and 17A); and 3 (Figs. 15B and 17B). Assuming the center frequency f of the 28 GHz band as 28 GHz, the thickness of the air layer in the IGU is 5.4 mm (Figs. 14B and 16B), 6.7 mm (Figs. 15A and 17A) or 8.0 mm (Figs. 15B and17B).

In the case where electromagnetic waves are perpendicularly incident as shown in Figs. 14A, 14B, 15A and 15B, Example of Fig. 14B in which the multiplication factor is 2 (even number) shows extremely low reflection at the air (the air layer in the IGU) and at the glass (the glass plate in the IGU), as in Examples of Fig. 14A in which the single plate is used. Further, Examples in which the insulated glass unit is used show the effect that the transmission loss is relatively reduced, as in Examples in which the single plate is used. Even in the case where the thickness of the air layer is not an even multiple, Examples show a reduced transmission loss, as compared to Comparative Examples, as shown in Figs. 15A, 15B, 17A and 17B. Although each figure shows the effect in the case of the insulated glass unit having two glass plates, the same effect can be obtained even in the case of an insulated glass unit having three or more glass plates (called a triple or more insulated glass unit).

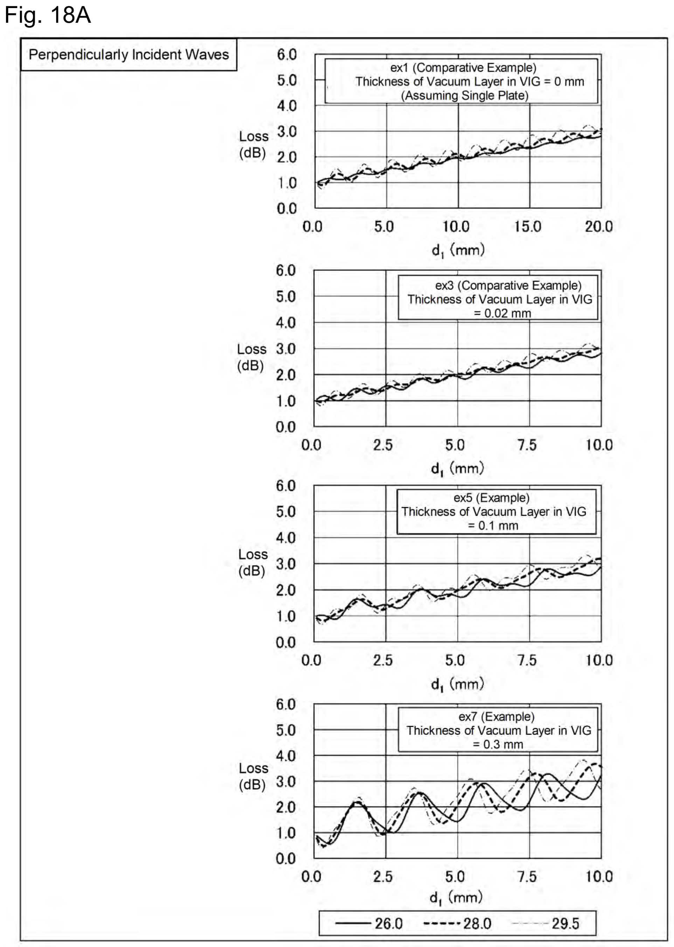

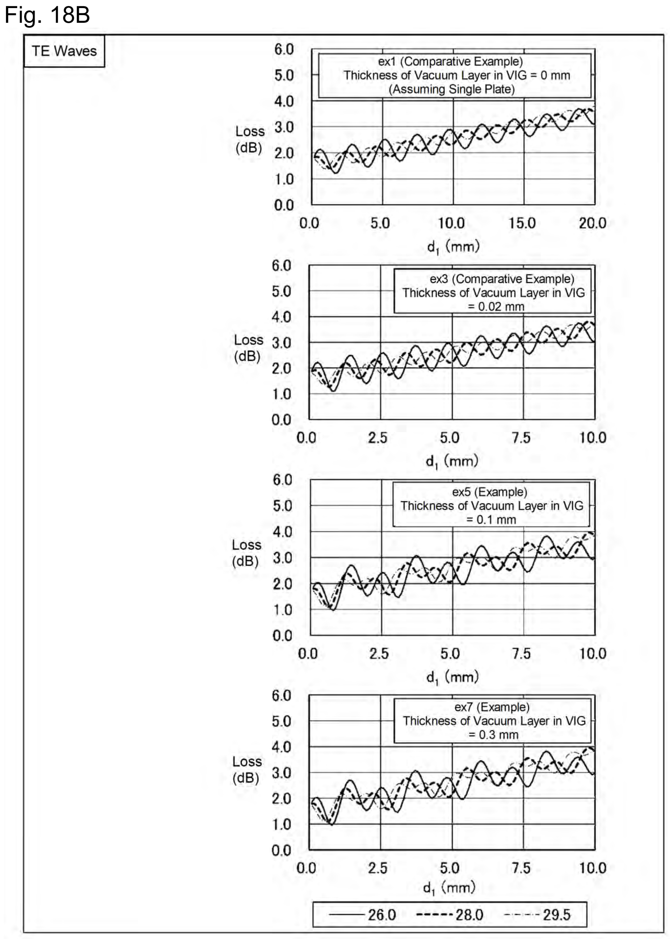

Figs. 18A and 18B are charts illustrating examples of simulations on the relationship between the thickness $d_1$ of the main substrate 50 in the form of vacuum insulated glass (VIG) and the transmission loss of the electromagnetic wave transparent body 301. Fig. 18A shows the simulation results in the case where electromagnetic waves are incident perpendicularly on the matching layer 70 at an incident angle $\alpha$ of 0°. Fig. 18B shows the simulation examples in the case where TE waves are incident obliquely on the matching layer at an incident angle $\alpha$ of 40°.

In the simulations of Figs. 18A and 18B, for the sake of simplicity, a pair of glass plates in the VIG are considered to have the same in thickness.

In the case where the main substrate 50 is in the form of VIG, the transmission loss of the electromagnetic wave transparent body 301 is influenced by the thickness of a vacuum layer between a pair of glass plate in the VIG. The thickness of the vacuum layer is smaller than the molecular mean free path within the space of the vacuum layer. In the simulations of Figs. 18A and 18B, the thickness of the vacuum layer in the VIG is 0.02 mm, 0.1 mm or 0.3 mm. Examples in which the vacuum insulated glass is used show the effect that the transmission loss is relatively reduced, as in Examples in which the single plate is used.

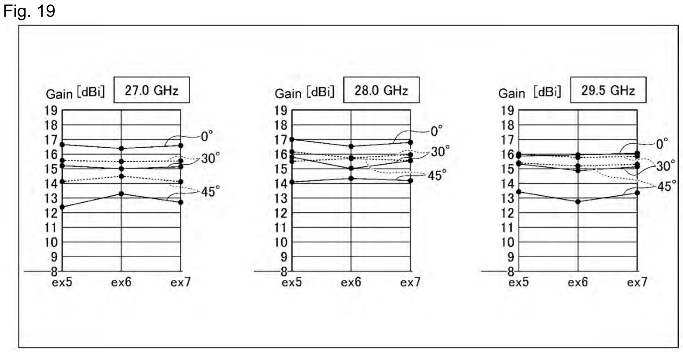

Fig. 19 is a chart illustrating examples of simulations on the antenna gain in the case where a phased array antenna is used as the antenna 30. In the simulations of Fig. 19, the horizontal scanning range of a beam radiated from the antenna 30 (phased array antenna) is set to 0°, 30° or 45°. In either case, good antenna gain is obtained.

The simulation conditions of Fig. 19 are set as follows.

Frequency f: three types such as 27.0 GHz, 28.0 GHz and 29.5 GHz
Relative permittivity $\varepsilon_{r1}$ of main substrate 50: 6.8
Dielectric loss tangent (tan$\delta$) of main substrate 50: 0.015
Relative permittivity $\varepsilon_{r3}$ of matching layer 70: 2.8
Dielectric loss tangent (tan$\delta$) of matching layer 70: 0.007
Intermediate layer 60: air layer

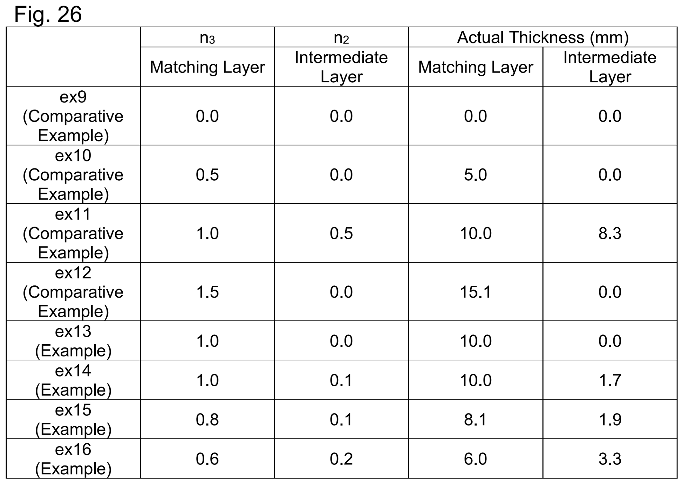

The relationship between the thickness $d_1$ of the main substrate 50 and the transmission loss of the electromagnetic wave transparent body 301 will be next described below taking, as an example, the case where the frequency f is in the 4.5 GHz band. Fig. 26 is a table illustrating, for each of ex9 to ex16, the values set for the pair $(n_3, n_2)$ and the actual thicknesses $d_2$ and $d_3$ of the intermediate layer 60 and the matching layer 70 in the case where the frequency f is 4.5 GHz.

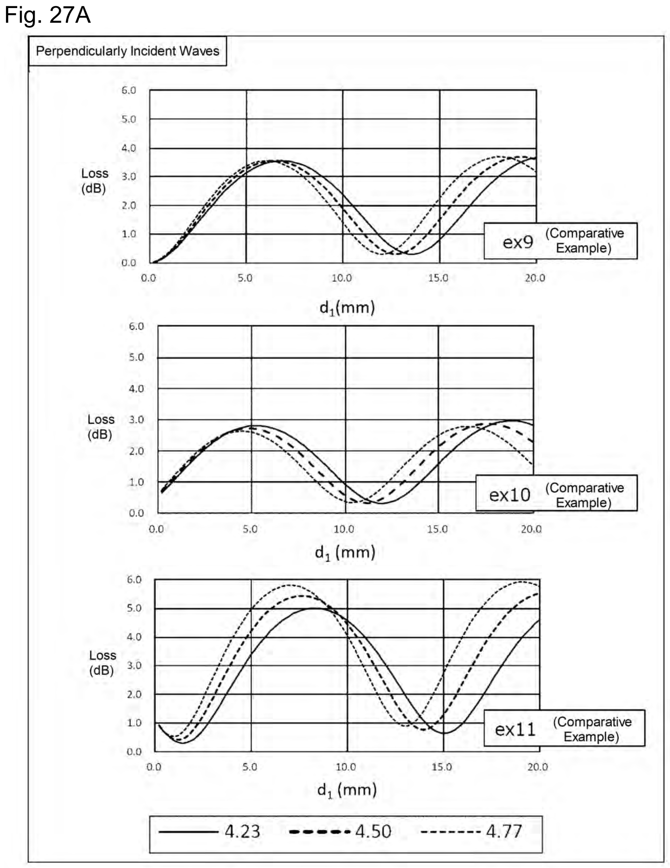

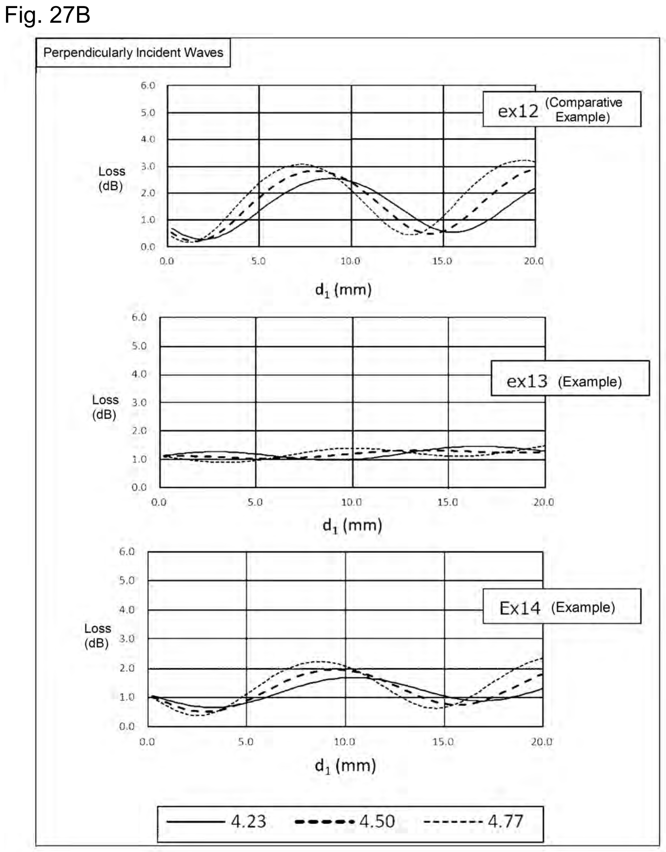

More specifically, examples of simulations performed in ex9 to ex18 on the relationship between the thickness $d_1$ of the main substrate 50 and the transmission loss of the electromagnetic wave transparent body 301 will be described below with reference to Figs. 27 to 30.

The simulation conditions of Figs. 27 to 30 are set as follows.

Frequency f: three types such as 4.23 GHz, 4.50 GHz and 4.77 GHz
Relative permittivity $\varepsilon_{r1}$ of main substrate 50: 6.8
Dielectric loss tangent (tan$\delta$) of main substrate 50: 0.015
Relative permittivity $\varepsilon_{r3}$ of matching layer 70: 2.8
Dielectric loss tangent (tan$\delta$) of matching layer 70: 0.007
Intermediate layer 60: air layer

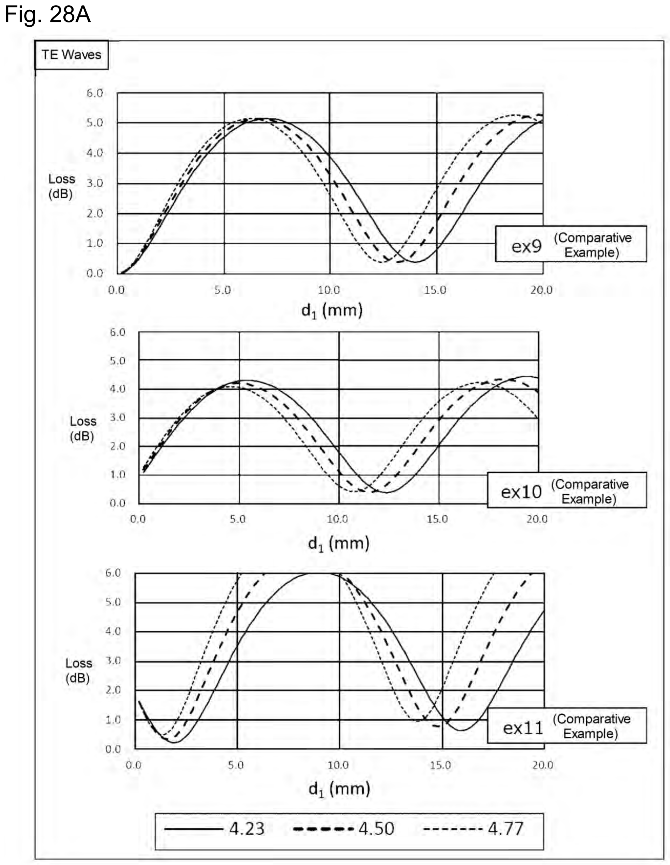

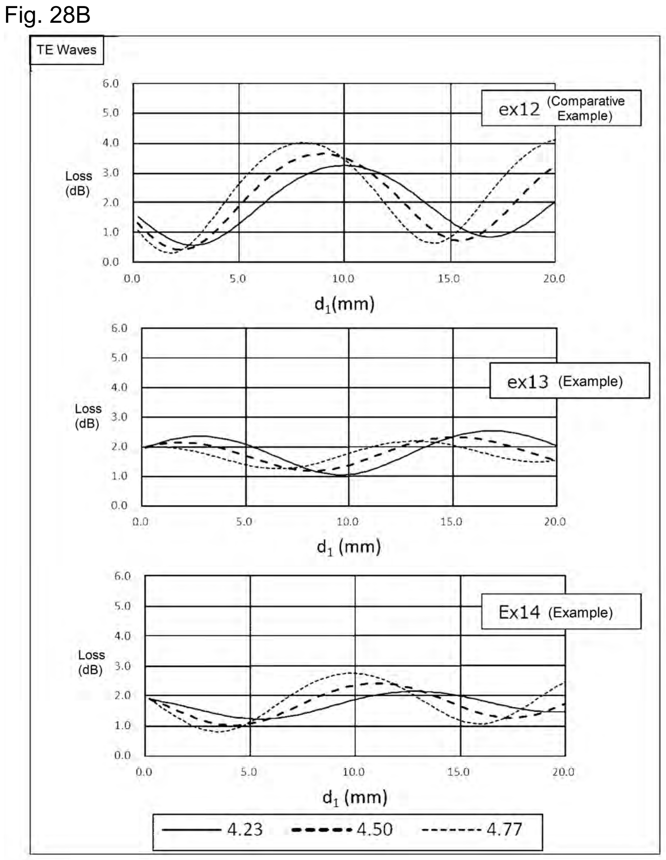

Figs. 27A and 27B are charts illustrating examples of simulations on the relationship between the thickness $d_1$ of the main substrate 50 and the transmission loss of the electromagnetic wave transparent body 301 in the case where electromagnetic waves are incident perpendicularly on the matching layer 70 at an incident angle $\alpha$ of 0°. Figs. 28A and 28B are charts illustrating examples of simulations on the relationship between the thickness $d_1$ of the main substrate 50 and the transmission loss of the electromagnetic wave transparent body 301 in the case where TE waves are incident obliquely on the matching layer 70 at an incident angle $\alpha$ of 40°.

When comparing Figs. 27A, 27B, 28A and 28B, the transmission loss is reduced in Examples satisfying the conditions B as compared to Comparative Examples not satisfying the conditions B. Further, variations in transmission loss relative to the thickness $d_1$ of the main substrate 50 are smaller in Examples satisfying the conditions B than in Comparative Examples not satisfying the conditions B, and thus, stable electromagnetic wave transmission performance is obtained in Examples.

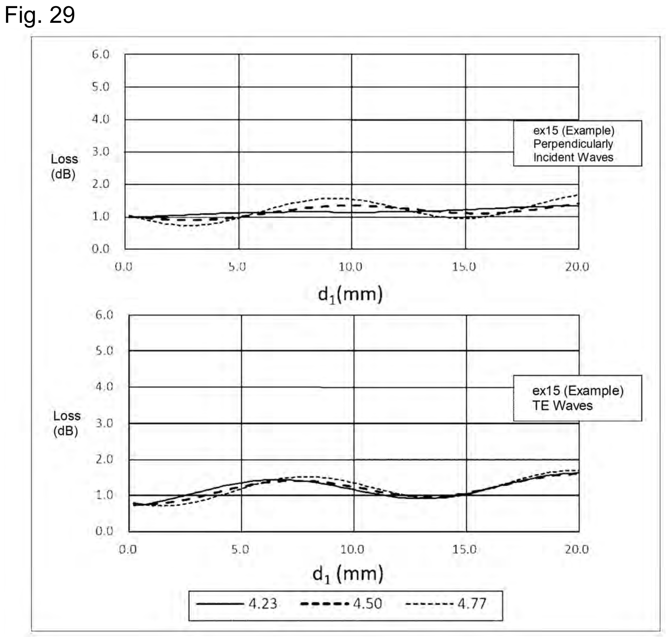

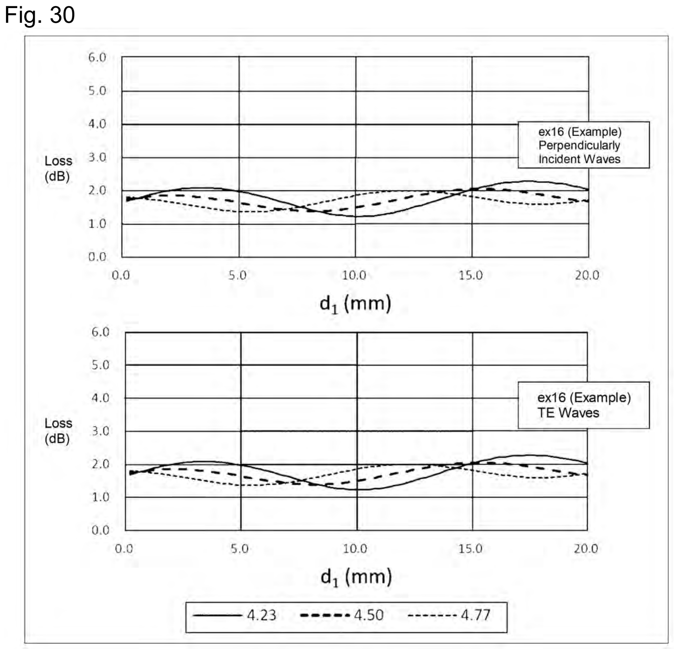

As seen from comparison of ex13 where no intermediate layer 60 is present and ex. 14 where the intermediate layer 60 is present in Figs. 27B and 28B, variations in transmission loss relative to the thickness $d_1$ of the main substrate 50 become large in the presence of the intermediate layer 60. When the thickness $d_3$ of the matching layer 70 is reduced by an amount of 20% to 40%, however, there can be obtained good electromagnetic wave transmission performance in which variations in transmission loss relative to the thickness $d_1$ of the main substrate 50 are suppressed (see Figs. 29 and 30).

Fig. 29 is a chart illustrating examples of simulations on the relationship between the thickness $d_1$ of the main substrate 50 and the transmission loss of the electromagnetic wave transparent body 301 in ex15 (Example). Fig. 30 is a chart illustrating examples of simulations on the relationship between the thickness $d_1$ of the main substrate 50 and the transmission loss of the electromagnetic wave transparent body 301 in ex16 (Example). In each of Figs. 29 and 30, one graph shows the simulation results in the case where electromagnetic waves are incident perpendicularly on the matching layer 70 at an incident angle $\alpha$ of 0°; and the other graph shows the simulation results in the case where TE waves are incident obliquely on the matching layer 70 at an incident angle $\alpha$ of 40°.

Variations in transmission loss relative to the thickness $d_1$ of the main substrate 50 are suppressed in ex15 (Fig. 29) and ex16 (Fig. 30) as compared to ex14 (Figs. 27B and 28B). The arrangement of the matching layer 70 in addition to the intermediate layer 60 such as air layer is significantly advantageous in reducing mechanical load (thermal cracking, warpage, peeling) in the case where the matching layer 70 differs in thermal expansion coefficient from the main substrate 50. For example, the matching layer 60 containing a resin has a higher thermal expansion coefficient than that of the main substrate 60 in the form of a glass plate.

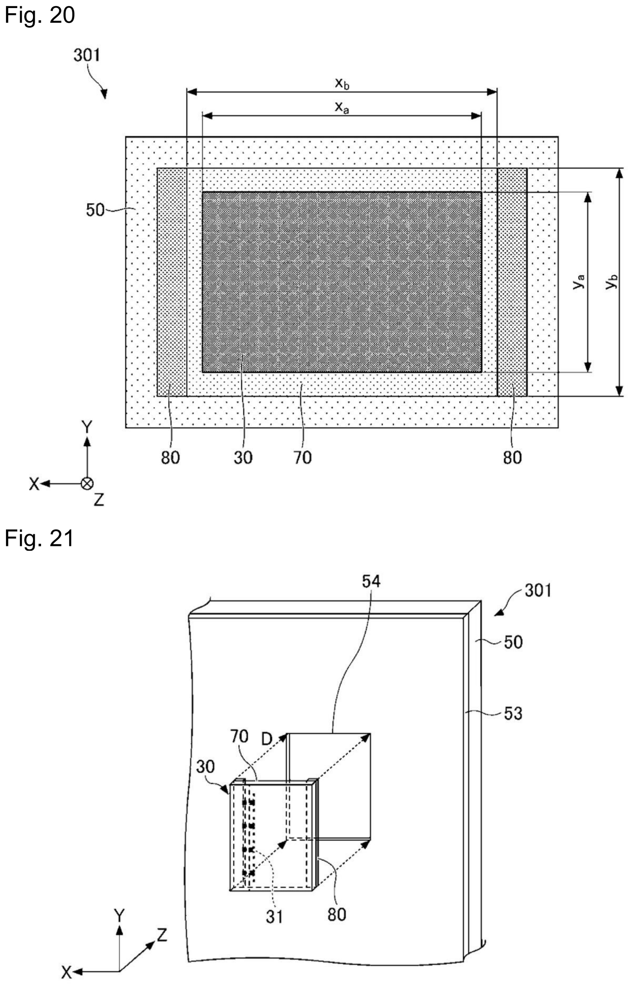

Fig. 20 is a plan view schematically illustrating the example of the electromagnetic wave transparent body according to one embodiment. Here, Fig. 20 shows the view from the indoor side.

The matching layer 70 preferably has an area large enough to cover the antenna 30 in plan view from the outdoor side (the back side of the paper). This enhances the effect of adjusting an impedance mismatch between the main substrate 50 on which electromagnetic waves received or transmitted by the antenna 30 are incident and the medium present between the antenna 30 and the main substrate 50.

For example, in plan view, the lateral size of the antenna 30 is denoted as $x_a$; the vertical size of the antenna 30 is denoted as $y_a$; and the lateral size of the matching layer 70 is denoted as $x_b$; and the vertical size of the matching layer 70 is denoted as $y_b$. The lateral size $x_a$ and vertical size $y_a$ of the antenna 30 may be defined by the sizes of an element arrangement region where one or more radiating elements are arranged, or may be defined by the sizes of an antenna aperture that is wider than the element arrangement region.

When the lateral size $x_b$ of the matching layer 70 is larger than or equal to $x_a$ and the vertical size $y_b$ of the matching layer 70 is larger than or equal to $y_a$, the impedance mismatch adjusting effect of the matching layer 70 is enhanced. The lateral size $x_b$ of the matching layer 70 is preferably larger than or equal to $x_a + C_0/f$; and the vertical size $y_b$ of the matching layer 70 is preferably larger than or equal to $y_a + C_0/f$. The upper limits of the lateral and vertical sizes $x_b$ and $y_b$ of the matching layer 70 are not particularly limited, but are preferably smaller than or equal to the size of the main substrate 50. Typically, the lateral size $x_b$ is preferably 2 m or smaller; and the vertical size $y_b$ is preferably 3 m or smaller.

Fig. 21 is a perspective view illustrating the example of the electromagnetic wave transparent body according to one embodiment. Here, Fig. 21 shows the view from the indoor side.

The main substrate 50 is not limited to a single plate, but may be made of laminated glass, an insulated glass unit, Low-E glass, light control glass or glass with linear member. The Low-E glass is also called low-emissivity glass, and may be one having a coating layer with heat ray reflecting function (a transparent conductive film) on a surface to be on the indoor side of window glass. The main substrate 53 may have a conductive layer 53 with heat ray reflecting function or the like. The conductive layer 53 is, for example, a coating layer formed on a principal surface of the main substrate 50 to be on the indoor side. The conductive layer 53 may be provided on an inner layer of the main substrate 50. The conductive layer 53 may have an opening 54 formed at a position facing at least a part of the antenna 30 (for example, one or more radiating elements 31 in the antenna 30) in plan view. The opening 54 is a portion of the conductive layer 53 where no conductor is provided. With the formation of the opening 54, a decrease in the electromagnetic wave transmission performance of the electromagnetic wave transparent body 301 can be suppressed. The number of openings 54 may be one or more. The shape of the opening 54 may be a rectangular shape, a circular shape, a slit shape or the like.

The conductive layer 53 may be a conductive film. Examples of the conductive film include a laminated film in which a transparent dielectric film, a metal film and a transparent dielectric film are sequentially laminated, a film of indium tin oxide (ITO), a film of fluorine-doped tin oxide, and the like. The metal film can be, for example, a film containing at least one type selected from the group consisting of silver, gold, copper and aluminum as a predominant component.

The antenna 30 may be fixed in position relative to the main substrate 50. For example, the antenna 30 is supported by a support portion 80 so as to face the main substate 50.

The support portion 80 secures the antenna 30 with a space left between the main substrate 50 and the antenna 30 or the matching layer 70. This space is, for example, a fluid layer such as air layer in the intermediate layer 60. With the formation of such a space between the main substrate 50 and the antenna 30 or the matching layer 70, convection is caused in the space due to the stack effect, which makes it possible to enhance heat dissipation from the antenna 30 and prevent cracking of the main substrate 50 (e.g. window glass) caused by heat.

The support portion 80 may be a spacer that ensures a space between the main substrate 50 and the antenna 30 or the matching layer 70. The support portion may be made of a dielectric base material. Examples of the material of the support portion 80 include conventionally known resins such as a polycarbonate resin, a polyphenylene ether resin, a polybutylene terephthalate resin, an ABS resin, a silicone resin, a polysulfide resin and an acrylic resin. Alternatively, a metal such as aluminum may be used.

The distance D between the main substrate 50 and the antenna 30 is, for example, 150 mm or less. When the distance D is from 3 mm to 20 mm, it is possible to achieve both of suppression of cracking of the main substrate 50 caused by heat and transmission of electromagnetic waves through the main substrate 50 and thereby possible to increase the effectiveness of the installation of the antenna 30. When the distance D is 3 mm or more, heat dissipation is enhanced so that the main substrate 50 is less likely to be cracked due to heat. When the distance D is 5 mm or more, heat dissipation from the antenna 30 is enhanced so that the main substrate 50 is further less likely to be cracked due to heat. When the distance D is 20 mm or less, an intensity decrease of the beam radiated through the main substrate 50 can be suppressed. When the distance D is 8 mm or less, an intensity decrease of the beam radiated through the main substrate 50 can be more suppressed. Further, the distance D may be more than or equal to $0.28\lambda g$ and less than or equal to $0.93\lambda g$ where $\lambda g$ is the wavelength of the operation frequency of the radiating element 31 in the antenna 30.

More specific embodiments of the electromagnetic wave transparent body will be described below.

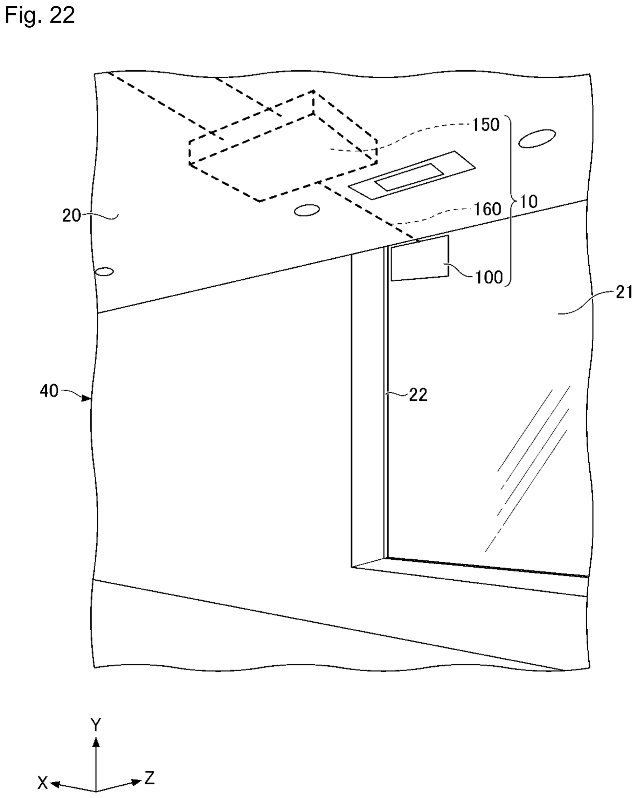

Fig. 22 is a schematic view illustrating a layout example of an antenna system 10 according to one embodiment. The antenna system 10 includes an antenna device 100, a digital control unit 150 arranged apart from window glass 21 and a plurality of wiring lines 160 connecting the antenna device 100 and the digital control unit 150. The antenna device 100 is installed and used in a state of facing an indoor-side surface of the window glass 21 of a building 40.

The window glass 21 is an example of the above-described main substrate 50. The antenna device 100 is provided with the above-described antenna 30. The antenna device 100 is a device installable with the above-described intermediate layer 60 sandwiched between the window glass 21 and the antenna device 100. The above-described matching layer 70 may be provided in the antenna device 100, may be provided on the indoor-side surface of the window glass 21, or may be a plate- or sheet-shaped component provided between the antenna device 100 and the main substrate 50.

The window glass 21 is a glass plate used for a window of a building etc. The window glass 21 is, for example, rectangular-shaped in plan view in the Z axis direction, and has a first glass surface and a second glass surface opposite the first glass surface. The thickness of the window glass 21 is set according to the specifications required of the building etc. Hereinafter, the first glass surface or the second glass surface may be occasionally referred to as a principal surface. In the present embodiment, the rectangular shape includes not only the shape of a rectangle or square but also the shape of a rounded rectangle or rounded square. The shape of the window glass 21 in plan view is not limited to a rectangular shape, and may be any other shape such as a circular shape. The window glass 21 may be attached to a window frame 22, which holds an outer edge of the window glass 21.

The window glass 21 is not limited to a single plate, and may be laminated glass, an insulated glass unit, Low-E glass, light control glass or glass with linear member. The Low-E glass is also referred to as low-emissivity glass, and may be one having a coating layer with heat ray reflecting function (a transparent conductive film) on the indoor-side surface of the window glass. In the case where the window glass is made of an insulated glass unit, a hollow-layer-side surface of the indoor-side glass plate of the insulated glass unit may be coated with a transparent conductive film. The coating layer may have an opening portion to suppress a decrease in the electromagnetic wave transmission performance. The opening portion is preferably provided at a position facing at least a part of the later-described plurality of radiating elements. The opening portion may be formed by patterning. Here, the term "patterning" means to leave a part of the coating layer in e.g. a lattice shape. A part of the opening portion may be patterned. The glass with linear member is glass having linear members of metal etc. embedded therein. The linear members may be arranged in mesh form and, in this case, the glass with linear member is also referred to as wired glass.

Examples of the material of the window glass 21 include soda-lime silica glass, borosilicate glass, aluminosilicate glass and alkali-free glass.

The thickness of the window glass 21 is preferably 1.0 to 20 mm. When the thickness of the window glass 21 is 1.0 mm or larger, the window glass has a sufficient strength for attachment of the antenna unit 100. When the thickness of the window glass 21 is 20 mm or smaller, the window glass shows good electromagnetic wave transmission performance. The thickness of the window glass 21 is more preferably 3.0 to 15 mm, still more preferably 6.0 to 12 mm.

In the example of Fig. 22, the antenna device 100 is used by being attached to the indoor-side of the window glass 21 of the building, to perform transmission and reception of electromagnetic waves in a quasi-millimeter band (20 GHz to 30 GHz) or a millimeter band (30 GHz to 300 GHz) through the window glass 21. The antenna device 100 is configured to allow transmission and reception of electromagnetic waves in compliance with, for example, the wireless communication standards such as 5th generation mobile communication systems (so-called 5G) or the wireless LAN (Local Area Network) standards such as IEEE 802.11ax or 802.11ay. The antenna device 100 may be configured to allow transmission and receipt of electromagnetic waves in compliance with the standards other than the above, and may be configured to allow transmission and receipt of electromagnetic waves of multiple different frequencies. The antenna device 100 can be applied, for example, to a wireless base station used facing the window glass 21.

The antenna device 100 of Fig. 22, facing the window glass 21 fixed to the building 40, can transmit a beam from a relatively low position toward the ground. This makes it possible to form a communication area of relatively high throughput between the antenna device 100 and the ground. Further, the antenna device 100, facing the window glass 21 fixed to the building 40, can easily transmit a beam while avoiding obstacles between the antenna device 100 and the ground. This also makes it possible to form a communication area of relatively high throughput between the antenna device 100 and the ground.

In the example of Fig. 22, the antenna device 100 is installed on the indoor side of the building 40 with respect to the window glass 21. This allows easy installation of the antenna device 100 because the installation of the antenna device can be done by indoor work.

The plurality of wiring lines 160 may include multiple types of wiring lines. Specific examples of the wiring lines 160 include coaxial cables, optical cables, flexible printed circuits, and the like. The antenna device 100 is connected to the digital control unit 150 via the plurality of wiring lines 160. The digital control unit 150 is a device that performs communication control and, because of its high power consumption of several hundred watts, generates a large amount of heat. For example, the amount of heat generated from the digital control unit 150 is larger than the amount of heat generated from the antenna device 100. The digital control unit 150 is arranged apart from the window glass 21 and, in the example of Fig. 22, is installed on the back side of a ceiling 20 so as to be hidden by the ceiling 20. The digital control unit 150 may be installed on a wall or a floor, or may be installed on the back side of the wall or under the floor. When the digital control unit 150 is arranged on the back side of the ceiling 20, on the back side of the wall or under the floor, the digital control unit 150 is inconspicuous to attain favorable design property.

The digital control unit 150 is preferably arranged at such a position that heat generated from the digital control unit 150 is not transmitted to the window glass 21 and, more specifically, arranged at a distance of 100 mm or more away from the window glass. The distance between the digital control unit 150 and the window glass 21 is more preferably 300 mm or more, still more preferably 1000 mm or more, yet more preferably 2000 mm or more, particularly preferably 5000 mm or more. The upper limit of the distance between the digital control unit 150 and the window glass 21 is not particularly limited, and is preferably 10000 mm or less with a view to suppressing a decrease in loss by the wiring lines 160.

The digital control unit 150 is connected to a communication network (not shown) via wiring lines such as optical cables and, in the case of the 5G, is connected to a distributed unit or a central unit and further connected to a 5G core network.

In the case where the window glass 21 is attached to the window frame 22, the antenna device 100 is preferably located at a distance of 20 mm or more away from the inner frame part of the window frame 22. When the antenna device 100 is located at a distance of 20 mm or more away from the window frame 22, a temperature gradient between the part of the window glass 21 facing the antenna device 100 and the part of the window glass 21 arranged in the window frame 22 can be decreased to reduce a thermal distortion in the window glass 21 whereby the window glass 21 is less likely to be broken. When the antenna device 100 is located at a distance of 20 mm or more from the inner frame part of the window frame 22, the antenna device 100 is spaced away from the window frame 22 and thus is easy to install.

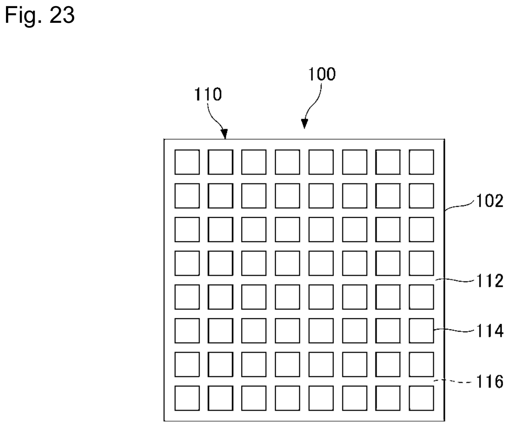

Fig. 23 is a schematic view illustrating the antenna device 100 in plan view according to one embodiment. The antenna device 100 has an array antenna 110 and an antenna aperture 102. The array antenna 110 is an example of the above-described antenna 30.

In Fig. 23, the antenna device 100 is a planar antenna device having at least one array antenna 110. The array antenna 110 is, for example, a microstrip array antenna having a substrate 112 between a plurality of radiating elements 114 arranged in a plane and a conductor 116. The plurality of radiating elements 114 are included in the antenna aperture 102 in plan view. When the antenna array 110 has light transmittance and is arranged facing the window glass, the view through the window glass can be secured. The array antenna 110 may alternatively be a slot array antenna.

In Fig. 23, the radiating element 114 are antenna conductors capable of transmitting and receiving electromagnetic waves in a desired frequency band. The desired frequency band can be, for example, a quasi-millimeter band ranging in frequency from 20 to 30 GHz, a millimeter band ranging in frequency from 30 to 300 GHz, or the like. The radiating elements 114 function as a radiating device (radiator).

The radiating elements 114 are provided on an outdoor-side first principal surface of the substrate 112. The radiating elements 114 may be formed by applying a metal material to the first principal surface of the substrate 112.

The radiating elements 114 are conductors formed in e.g. a flat shape. Examples of the metal material for formation of the radiating elements 114 include conductive materials such as gold, silver, copper, aluminum, chromium, lead, zinc, nickel and platinum. The conductive material may be an alloy such as, for example, an alloy of copper and zinc (brass), an alloy of silver and copper, an alloy of silver and aluminum, or the like. The radiating elements 114 may be in the form of a thin film. The shape of the radiating elements 114 may be, but is not limited to, a rectangular shape or a circular shape. The radiating elements 114 may have a linear shape or a plate shape as typified by a dipole antenna element.

Other examples of the material for formation of the radiating elements 114 include fluorine-doped tin oxide (FTO), indium tin oxide (ITO), and the like.

Although the radiating elements 114 are provided on the first principal surface of the substrate 112 in the present embodiment, the radiating elements 114 may be provided inside the substrate 112. In such a case, the radiating elements 114 may be provided in e.g. a coil shape inside the substrate 112.

In the case where the substrate 112 is of laminated glass having a pair of glass plates and a resin layer between the pair of glass plates, the radiating elements 114 may be provided between the glass plate and the resin layer of the laminated glass.

The radiating elements 114 themselves may be formed in a flat plate shape. In this case, the radiating elements 114 in a flat plate shape may be directly attached to a support portion without using the substrate 112.

The radiating elements 114 may be provided in a container, rather than provided on the substrate 112. In this case, the radiating elements 114 may be, for example, formed in a flat plate shape and installed in the container. The shape of the container is not particularly limited, and may be a rectangular shape. The substrate 112 may constitute a part of the container.

The radiating elements 114 may have light transmittance. When the radiating elements 114 have light transmittance, favorable design property can be obtained, and average solar absorptance can be decreased. In this case, the visible light transmittance of the radiating elements 114 is preferably 40% or higher, more preferably 60% or higher, with a view to maintaining the function as window glass in terms of transparency. Here, the visible light transmittance can be determined according to JIS R 3106 (2019).

The radiating elements 114 may be in mesh form to show light transmittance. Here, the term "mesh" means a state in which a plane of the radiating elements 114 have a network of through holes formed therein.

In the case where the radiating elements 114 are in mesh form, the openings of the mesh may be square-shaped or rhombus-shaped. The line width of the mesh is preferably 0.1 to 30 $\mu$m, more preferably 0.2 to 15 $\mu$m. The line spacing of the mesh is preferably 5 to 500 $\mu$m, more preferably 10 to 300 $\mu$m.

The opening rate of the radiating elements 114 is preferably 80% or higher, more preferably 90% or higher. The opening rate of the radiating elements 114 refers to the proportion of the area of the openings formed in the radiating elements 114 to the total area of the radiating elements 114 including the openings. The higher the opening rate of the radiating elements 114, the higher the visible light transmittance of the radiating elements 114.

The thickness of the radiating elements 114 is preferably 400 nm or smaller, more preferably 300 nm or smaller. The lower limit of the thickness of the radiating elements 114 is not particularly limited, and may be 2 nm or larger, may be 10 nm or larger or may be 30 nm or larger.

In the case where the radiating elements 114 are in mesh form, the thickness of the radiating elements 114 may be 0.2 to 40 $\mu$m. The radiating elements 114 in mesh form can achieve high visible light transmittance even when large in thickness.

The substrate 112 is a substrate provided e.g. in parallel with the window glass. For example, the substrate 112 is rectangular-shaped in plan view, and has a first principal surface and a second principal surface. The first principal surface of the substrate 112 is directed to the outdoor side and, in the first embodiment, arranged facing the indoor-side glass surface of the window glass. The second principal surface of the substrate 112 is directed to the indoor side and, in the first embodiment, arranged facing in the same direction as the indoor-side glass surface of the window glass.

The substrate 112 may be disposed at a predetermined angle with respect to the window glass. The antenna device 100 may radiate electromagnetic waves in a state where (the direction normal to) the substrate 112 on which the radiating elements 114 are arranged is inclined relative to (the direction normal to) the window glass.

The material for formation of the substrate 112 is designed according to the antenna performance such as power and directivity required for the radiating elements 114. Examples of the material of the substrate 112 include dielectric materials such glass and resins. The substrate 112 may be formed of a dielectric material such as glass or a resin to show light transmittance. By forming the substrate 112 of a light transmissive material, it is possible to reduce obstruction of the view through the window glass.

When glass is used as the material of the substrate 112, the glass can be, for example, soda-lime silica glass, borosilicate glass, aluminosilicate glass, quartz glass, alkali-free glass or the like.

A plate of the glass used as the substrate 112 can be produced by a known production method such as a float process, a fusion process, a redraw process, a press-forming process, a vertical draw process or the like. As the method for production of the glass plate, preferred is a float process in view of excellent productivity and cost performance.

The glass plate is formed in a rectangular shape in plan view. As a method for cutting the glass plate, for example, there may be mentioned a method of emitting laser light onto the surface of the glass plate while moving the emission area of the laser light on the surface of the glass plate, or a mechanical cutting method using a cuter wheel.

In the present embodiment, the rectangular shape includes not only the shape of a rectangle or a square but also the shape of a rounded rectangle or rounded square. The shape of the glass plate in plan view is not limited to a rectangular shape, but may be any other shape such as a circular shape. Further, the glass plate is not limited to a single plate, and may be a laminated glass plate or an insulated glass unit.

When a resin is used as the material of the substrate 112, the resin can be, for example, liquid crystal polymer (LCP), polyphenylene ether (PPE), polycarbonate, a fluororesin or the like. A fluororesin is preferred in view of its low dielectric constant and low dielectric loss.

Examples of the fluororesin include an ethylene-tetrafluoroethylene copolymer (also referred to as "ETFE"), a hexafluoropropylene-tetrafluoroethylene copolymer (also referred to as "FEP"), a tetrafluoroethylene-propylene copolymer, a tetrafluoroethylene-hexafluoropropylene-propylene copolymer, a perfluoro (alkyl vinyl ether)-tetrafluoroethylene copolymer (also referred to as "PFA"), a tetrafluoroethylene-hexafluoropropylene-vinylidene fluoride copolymer (also referred to as "THV"), polyvinylidene fluoride (also referred to as "PVDF"), a vinylidene fluoride-hexafluoropropylene copolymer, a polyvinyl fluoride, a chlorotrifluoroethylene polymer, an ethylene-chlorotrifluoroethylene copolymer (also referred to as "ECTFE"), a polytetrafluoroethylene and the like. These fluororesins can be used alone or in combination of two or more types thereof.

The fluororesin is preferably at least one selected from the group consisting of ETFE, FEP, PFA, PVDF, ECTFE and THV. ETFE is particularly preferred in view of its excellent transparency, processability and weather resistance.

The thickness h of the substrate 112 is preferably 25 $\mu$m to 10 mm. The thickness h of the substrate 112 can be freely designed according to the position of arrangement of the radiating elements 114.

In the case where the substrate 112 is made of a resin, the resin is preferably used in the form of a film or sheet. The thickness h of the film or sheet is preferably 25 to 1000 $\mu$m, more preferably 50 to 800 $\mu$m, with a view to obtaining high strength to hold the antenna.

In the case where the substrate 112 is made of glass, the thickness h of the substrate 112 is preferably 0.5 to 10 mm in view of strength to hold the antenna.

The arithmetic mean roughness Ra of the outdoor-side first principal surface of the substrate 112 is preferably 1.2 $\mu$m or smaller. When the arithmetic mean roughness Ra of the first principal surface is 1.2 $\mu$m or smaller, air is easy to flow in a space between the substrate 112 and the window glass. The arithmetic mean roughness Ra of the first principal surface is more preferably 0.6 $\mu$m or smaller, still more preferably 0.3 $\mu$m or smaller. The lower limit of the arithmetic mean roughness Ra of the first principal surface is not particularly limited, and may be, for example, 0.001 $\mu$m or greater.

Here, the arithmetic mean roughness Ra can be determined according to Japanese Industrial Standards: JIS B0601:2001.

The area of the substrate 112 is preferably 0.001 to 4 $m^2$. When the area of the substrate 112 is 0.001 $m^2$ or larger, it is easy to form the radiating elements 114 and the conductor 116. When the area of the substrate is 4 $m^2$ or smaller, the array antenna 110 or the antenna device 100 is less conspicuous in appearance and favorable in design property. The area of the substrate 112 is more preferably 0.05 to 2 $m^2$.

The conductor 116 may be provided on the second principal surface of the substrate 112 opposite from the window glass. The conductor 116 is disposed on the indoor side with respect to the radiating elements 114. The conductor 116 may be a part which functions as an electromagnetic shielding layer capable of reducing electromagnetic interference between electromagnetic waves radiated from the radiating elements 114 and electromagnetic waves generated from indoor electronic equipment. The conductor 116 may have a single-layer structure or a multi-layer structure. A known material is usable as the material of the conductor 116. The conductor 116 can be, for example, a film of metal such as copper or tungsten, a transparent substrate using a transparent conductive film, or the like.

The transparent conductive film may be made of, for example, a light transmissive conductive material such as indium tin oxide (ITO), fluorine-doped tin oxide (FTO), indium zinc oxide (IZO), silicon oxide-doped indium tin oxide (ITSO), zinc oxide (ZnO), or a Si compound containing P or B.

The conductor 116 is, for example, a conductor plane formed in a flat plate shape. The planar shape of the conductor may be a rectangular shape or a circular shape, but is not limited to such a shape.

The conductor 116 may be in mesh form to show light transmittance. Here, the term "mesh" means a state in which a plane of the conductor 116 has a network of through holes formed therein. In the case where the conductor 116 is in mesh form, the openings of the mesh may be square-shaped or rhombus-shaped. The line width of the mesh is preferably 0.1 to 30 $\mu$m, more preferably 0.2 to 15 $\mu$m. The line spacing of the mesh is preferably 5 to 500 $\mu$m, more preferably 10 to 300 $\mu$m.

The conductor 116 can be formed by a known method such as, for example, a sputtering method, a vapor deposition method or the like.

The surface resistivity of the conductor 116 is preferably 20 $\Omega$/sq or lower, more preferably 10 $\Omega$/sq or lower, still more preferably 5 $\Omega$/sq or lower. The conductor 116 is preferably larger in size than the substrate 112, but may be smaller in size than the substrate 112. By providing the conductor 116 on the indoor-side second principal surface of the substrate 112, it is possible to suppress transmission of electromagnetic waves to the indoors. The surface resistivity of the conductor 116 varies depending on the thickness, material and opening rate of the conductor 116. The opening rate refers to the proportion of the area of the openings formed in the conductor 116 to the total area of the conductor 116 including the openings.

The visible light transmittance of the conductor 116 is preferably 40% or higher, more preferably 60% or higher, with a view to improving design property. The visible light transmittance of the conductor 116 is preferably 90% or lower, more preferably 80% or lower, with a view to suppressing transmission of electromagnetic waves to the indoors.

The higher the opening rate of the conductor 116, the higher the visible light transmittance of the conductor. The opening rate of the conductor 116 is preferably 80% or higher, more preferably 90% or higher. The opening rate of the conductor 116 is preferably 95% or lower with a view to suppressing transmission of electromagnetic waves to the indoors.

The thickness of the conductor 116 is preferably 400 nm or smaller, more preferably 300 nm or smaller. The lower limit of the thickness of the conductor 116 is not particularly limited, and may be 2 nm or larger, may be 10 nm or larger or may be 30 nm or larger.

In the case where the conductor 116 is in mesh form, the thickness of the conductor 116 may be 0.2 to 40 $\mu$m. The conductor 116 in mesh form can achieve high visible light transmittance even when large in thickness.

The radiating elements 114 are patch elements (patch antenna), but may be any other elements such as dipole elements (dipole antenna) or slot elements (slot antenna).

Although the embodiments of the present disclosure have been described above, the above-described embodiments are illustrative only and are not intended to limit the present invention thereto. The above-described embodiments can be implemented in various other forms, and various combinations, omissions, replacements, changes and the like can be made without departing from the scope of the invention. These embodiments and modifications thereof are included in the scope and gist of the present invention, and are also included in the scope of the preset invention as defined by the appended claims and their equivalents.

For example, the antenna device 100 does not have to be fixed to the main substrate 50 such as the window glass 21. The antenna device 100 may be hung from the ceiling, or fixed to a protrusion present around the main substrate 50 (for example, a window frame or a window sash etc. for holding the outer edge of the window glass), so as to be installed and used in a state of facing the window glass. The antenna device 100 may be installed in contact with the main substrate 50, or may be installed in proximity to but without being in contact with the main substrate 50.

Furthermore, the antenna device 100 does not have to be arranged on the indoor side to face the indoor-side surface of the main substrate 50 such as the window glass 21, and may be arranged on the outdoor side to face the outdoor-side surface of the main substrate 50.

The entire disclosure of Japanese Patent Application No. 2023-074385 filed on April 28, 2023, including specification, claims, drawings and summary, is incorporated herein by reference in its entirety.

REFERENCE SYMBOLS

10: Antenna system
20: Ceiling
21: Window glass
22: Window frame
30: Antenna
31: Radiating element
40: Building
50: Main substrate
53: Conductive layer
54: Opening
60: Intermediate layer
70: Matching layer
80: Support part
100: Antenna device
102: Antenna aperture
110: Array antenna
112: Base
114: Radiating element
116: Conductor
120: Housing
140: Heat sink
150: Digital control unit
160: Wiring
200: Fixing part
301: Electromagnetic wave transparent body

**Claims**

1. An electromagnetic wave transparent body comprising:

a main substrate having, at a frequency f of electromagnetic wave, a relative permittivity $\varepsilon_{r1}$ of from 4 to 7 and a dielectric loss tangent of 1.4/f or less;
an intermediate layer located on a first side with respect to the main substrate and having, at the frequency f, a relative permittivity $\varepsilon_{r2}$ of from 1 to 1.5 and a dielectric loss tangent of 1.4/f or less; and
a matching layer located on the first side with respect to the intermediate layer and having, at the frequency f, a relative permittivity $\varepsilon_{r3}$ of from 0.7 times to 1.3 times a value of $\sqrt{(\varepsilon_{r1})}$ and a dielectric loss tangent of 1.4/f or less, the electromagnetic wave transparent body satisfying the following formulas:

$$(n_1-0.3)\times(C_0/(4\times f\times \sqrt{(\varepsilon_{r1})})) \leq d_1 \leq (n_1+0.3)\times(C_0/(4\times f\times \sqrt{(\varepsilon_{r1})}));$$

$$d_2 = n_2\times C_0/(4\times f\times \sqrt{(\varepsilon_{r2})});$$

$$d_3 = n_3\times C_0/(4\times f\times \sqrt{(\varepsilon_{r3})});$$

$$0 \leq n_2 \leq 2;$$

$$0 < n_3 \leq 3;$$

$$(((n_3-1)\cos\theta+(n_2-a_2)\sin\theta)/a_3)^2+((-(n_3-1)\sin\theta+(n_2-a_2)\cos\theta)/a_4)^2 \geq 1;$$

$$(((n_3-3)\cos\theta+(n_2-a_2)\sin\theta)/a_3)^2+((-(n_3-3)\sin\theta+(n_2-a_2)\cos\theta)/a_4)^2 \geq 1;$$

$$\theta = -38°;$$

$$a_2 = 1;$$

$$a_3 = 1.2;$$

and

$$a_4 = 0.6,$$

where $d_1$ is a total thickness of the main substrate; $d_2$ is a thickness of the intermediate layer; $d_3$ is a thickness of the matching layer; $C_0$ is a speed of the electromagnetic wave in air; and $n_1$ is an even number from 2 to 20.

2. An electromagnetic wave transparent body comprising:

a main substrate having, at a frequency f of electromagnetic wave, a relative permittivity $\varepsilon_{r1}$ of from 4 to 7 and a dielectric loss tangent of 1.4/f or less;
an intermediate layer located on a first side with respect to the main substrate and having, at the frequency f, a relative permittivity $\varepsilon_{r2}$ of from 1 to 1.5 and a dielectric loss tangent of 1.4/f or less; and
a matching layer located on the first side with respect to the intermediate layer and having, at the frequency f, a relative permittivity $\varepsilon_{r3}$ of from 0.7 times to 1.3 times a value of $\sqrt{(\varepsilon_{r1})}$ and a dielectric loss tangent of 1.4/f or less, the electromagnetic wave transparent body satisfying the following formulas:

$$d_1 = n_1\times C_0/(4\times f\times \sqrt{(\varepsilon_{r1})});$$

$$d_2 = n_2\times C_0/(4\times f\times \sqrt{(\varepsilon_{r2})});$$

$$d_3 = n_3 \times C_0/(4 \times f \times \sqrt{(\varepsilon_{r3})});$$

$$0.5 \le n_1 \le 20;$$

$$0 \le n_2 \le 2;$$

$$0 < n_3 \le 3;$$

$$\theta = -25°;$$

$$a_2 = 0;$$

$$a_3 = 0.8;$$

$$a_4 = 0.14;$$

and

$$(((n_3-1)\cos\theta+(n_2-a_2)\sin\theta)/a_3)^2+((-(n_3-1)\sin\theta+(n_2-a_2)\cos\theta)/a_4)^2 \le 1;$$

or

$$(((n_3-3)\cos\theta+(n_2-a_2)\sin\theta)/a_3)^2+((-(n_3-3)\sin\theta+(n_2-a_2)\cos\theta)/a_4)^2 \le 1,$$

where $d_1$ is a total thickness of the main substrate; $d_2$ is a thickness of the intermediate layer; $d_3$ is a thickness of the matching layer; and $C_0$ is a speed of the electromagnetic wave in air.

3. The electromagnetic wave transparent body according to Claim 1 or 2, wherein:

the frequency f is included in a band with a fractional bandwidth of 12%; and
a transmission loss of the electromagnetic wave transparent body is 2.5 dB or less in 70% or more of the band.

4. The electromagnetic wave transparent body according to Claim 3, wherein the main substrate is a glass plate for buildings.

5. The electromagnetic wave transparent body according to Claim 3, wherein the intermediate layer comprises a gas layer or a solid layer.

6. The electromagnetic wave transparent body according to Claim 5, wherein:

the intermediate layer comprises a gas layer and a solid layer; and
the gas layer is located between the main substrate and the solid layer.

7. The electromagnetic wave transparent body according to Claim 5, wherein the solid layer contains a foam.

8. The electromagnetic wave transparent body according to Claim 3, wherein a solar absorptance of a layered body formed by the intermediate layer and the matching layer or, when an antenna is provided on the first side of the matching layer, a solar absorptance of a layered body formed by the intermediate layer, the matching layer and the antenna, is 60% or lower.

9. The electromagnetic wave transparent body according to Claim 3, further comprising an antenna located on the first side with respect to the matching layer.

10. The electromagnetic wave transparent body according to Claim 9, wherein a distance between the main substrate and the antenna is 150 mm or less.

11. The electromagnetic wave transparent body according to Claim 9, wherein the matching layer has an area large enough to cover the antenna in plan view.

12. The electromagnetic wave transparent body according to Claim 11, wherein, in plan view, the matching layer has a lateral size larger than or equal to $x_a$ and a vertical size larger than or equal to $y_a$ where $x_a$ is a lateral size of the antenna; and $y_a$ is a vertical size of the antenna.

13. The electromagnetic wave transparent body according to Claim 9, wherein the main substrate comprises a conductive layer having an opening at a position facing at least a part of the antenna.

14. A matching body installable with an intermediate layer sandwiched between a main substrate and the matching body, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching body is located on the first side with respect to the intermediate layer and has, at the frequency f, a relative permittivity $\varepsilon_{r3}$ of from 0.7 times to 1.3 times a value of $\sqrt{(\varepsilon_{r1})}$ and a dielectric loss tangent of 1.4/f or less; and
the matching body satisfies the following formulas:

$$(n_1-0.3)\times(C_0/(4\times f\times\sqrt{(\varepsilon_{r1})})) \leq d_1 \leq (n_1+0.3)\times(C_0/(4\times f\times\sqrt{(\varepsilon_{r1})}));$$

$$d_2 = n_2\times C_0/(4\times f\times\sqrt{(\varepsilon_{r2})});$$

$$d_3 = n_3\times C_0/(4\times f\times\sqrt{(\varepsilon_{r3})});$$

$$0 \leq n_2 \leq 2;$$

$$0 < n_3 \leq 3;$$

$$(((n_3-1)\cos\theta+(n_2-a_2)\sin\theta)/a_3)^2+((-(n_3-1)\sin\theta+(n_2-a_2)\cos\theta)/a_4)^2 \geq 1;$$

$$(((n_3-3)\cos\theta+(n_2-a_2)\sin\theta)/a_3)^2+((-(n_3-3)\sin\theta+(n_2-a_2)\cos\theta)/a_4)^2 \geq 1;$$

$$\theta = -38°;$$

$$a_2 = 1;$$

$$a_3 = 1.2;$$

and

$$a_4 = 0.6,$$

where $d_1$ is a total thickness of the main substrate; $d_2$ is a thickness of the intermediate layer; $d_3$ is a thickness of the matching body; $C_0$ is a speed of the electromagnetic wave in air; and $n_1$ is an even number from 2 to 20.

15. A matching body installable with an intermediate layer sandwiched between a main substrate and the matching body, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching body is located on the first side with respect to the intermediate layer and has, at the frequency f, a relative permittivity $\varepsilon_{r3}$ of from 0.7 times to 1.3 times a value of $\sqrt{(\varepsilon_{r1})}$ and a dielectric loss tangent of 1.4/f or less; and
the matching body satisfies the following formulas:

$$d_1 = n_1 \times C_0/(4 \times f \times \sqrt{(\varepsilon_{r1})});$$

$$d_2 = n_2 \times C_0/(4 \times f \times \sqrt{(\varepsilon_{r2})});$$

$$d_3 = n_3 \times C_0/(4 \times f \times \sqrt{(\varepsilon_{r3})});$$

$$0.5 \le n_1 \le 20;$$

$$0 \le n_2 \le 2;$$

$$0 < n_3 \le 3;$$

$$\theta = -25°;$$

$$a_2 = 0;$$

$$a_3 = 0.8;$$

$$a_4 = 0.14;$$

and

$$(((n_3-1)\cos\theta+(n_2-a_2)\sin\theta)/a_3)^2+((-(n_3-1)\sin\theta+(n_2-a_2)\cos\theta)/a_4)^2 \le 1;$$

or

$$(((n_3-3)\cos\theta+(n_2-a_2)\sin\theta)/a_3)^2+((-(n_3-3)\sin\theta+(n_2-a_2)\cos\theta)/a_4)^2 \le 1,$$

where $d_1$ is a total thickness of the main substrate; $d_2$ is a thickness of the intermediate layer; $d_3$ is a thickness of the matching body; and $C_0$ is a speed of the electromagnetic wave in air.

16. An antenna device installable with an intermediate layer sandwiched between a main substrate and the antenna device,
the antenna device comprising a matching layer and an antenna, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;

the matching layer is located on the first side with respect to the intermediate layer and has, at the frequency f, a relative permittivity $\varepsilon_{r3}$ of from 0.7 times to 1.3 times a value of $\sqrt{(\varepsilon_{r1})}$ and a dielectric loss tangent of 1.4/f or less; the antenna is located on the first side with respect to the matching layer; and the antenna device satisfies the following formulas:

$$(n_1-0.3)\times(C_0/(4\times f\times\sqrt{(\varepsilon_{r1})})) \leq d_1 \leq (n_1+0.3)\times(C_0/(4\times f\times\sqrt{(\varepsilon_{r1})}));$$

$$d_2 = n_2\times C_0/(4\times f\times\sqrt{(\varepsilon_{r2})});$$

$$d_3 = n_3\times C_0/(4\times f\times\sqrt{(\varepsilon_{r3})});$$

$$0 \leq n_2 \leq 2;$$

$$0 < n_3 \leq 3;$$

$$(((n_3-1)\cos\theta+(n_2-a_2)\sin\theta)/a_3)^2+((-(n_3-1)\sin\theta+(n_2-a_2)\cos\theta)/a_4)^2 \geq 1;$$

$$(((n_3-3)\cos\theta+(n_2-a_2)\sin\theta)/a_3)^2+((-(n_3-3)\sin\theta+(n_2-a_2)\cos\theta)/a_4)^2 \geq 1;$$

$$\theta = -38°;$$

$$a_2 = 1;$$

$$a_3 = 1.2;$$

and

$$a_4 = 0.6,$$

where $d_1$ is a total thickness of the main substrate; $d_2$ is a thickness of the intermediate layer; $d_3$ is a thickness of the matching layer; $C_0$ is a speed of the electromagnetic wave in air; and $n_1$ is an even number from 2 to 20.

17. An antenna device installable with an intermediate layer sandwiched between a main substrate and the antenna device,
the antenna device comprising a matching layer and an antenna, wherein:

the main substrate has, at a frequency f of electromagnetic wave, a relative permittivity $\varepsilon_{r1}$ of from 4 to 7 and a dielectric loss tangent of 1.4/f or less;
the intermediate layer is located on a first side with respect to the main substrate and has, at the frequency f, a relative permittivity $\varepsilon_{r2}$ of from 1 to 1.5 and a dielectric loss tangent of 1.4/f or less;
the matching layer is located on the first side with respect to the intermediate layer and has, at the frequency f, a relative permittivity $\varepsilon_{r3}$ of from 0.7 times to 1.3 times a value of $\sqrt{(\varepsilon_{r1})}$ and a dielectric loss tangent of 1.4/f or less;
the antenna is located on the first side with respect to the matching layer; and
the antenna device satisfies the following formulas:

$$d_1 = n_1\times C_0/(4\times f\times\sqrt{(\varepsilon_{r1})});$$

$$d_2 = n_2\times C_0/(4\times f\times\sqrt{(\varepsilon_{r2})});$$

$$d_3 = n_3 \times C_0/(4 \times f \times \sqrt{(\varepsilon_{r3})});$$

$$0.5 \leq n_1 \leq 20;$$

$$0 \leq n_2 \leq 2;$$

$$0 < n_3 \leq 3;$$

$$\theta = -25°;$$

$$a_2 = 0;$$

$$a_3 = 0.8;$$

$$a_4 = 0.14;$$

and

$$(((n_3-1)\cos\theta+(n_2-a_2)\sin\theta)/a_3)^2+((-(n_3-1)\sin\theta+(n_2-a_2)\cos\theta)/a_4)^2 \leq 1;$$

or

$$(((n_3-3)\cos\theta+(n_2-a_2)\sin\theta)/a_3)^2+((-(n_3-3)\sin\theta+(n_2-a_2)\cos\theta)/a_4)^2 \leq 1,$$

where $d_1$ is a total thickness of the main substrate; $d_2$ is a thickness of the intermediate layer; $d_3$ is a thickness of the matching layer; and $C_0$ is a speed of the electromagnetic wave in air.

Fig. 1

Fig. 2

Fig. 3

Fig. 4

Fig. 5

Fig. 6

Fig. 7

Fig. 8

Fig. 9

| | n3 | n2 | Actual Thickness (mm) | Actual Thickness (mm) |
|---|---|---|---|---|
| | Matching Layer | Intermediate Layer | Matching Layer | Intermediate Layer |
| ex1 (Comparative Example) | 0.0 | 0.0 | 0.0 | 0.0 |
| ex2 (Comparative Example) | 0.5 | 0.0 | 0.8 | 0.0 |
| ex3 (Comparative Example) | 1.0 | 0.5 | 1.6 | 1.3 |
| ex4 (Comparative Example) | 1.5 | 0.0 | 2.4 | 0.0 |
| ex5 (Example) | 1.0 | 0.0 | 1.6 | 0.0 |
| ex6 (Example) | 1.0 | 0.1 | 1.6 | 0.3 |
| ex7 (Example) | 0.8 | 0.1 | 1.3 | 0.3 |
| ex8 (Example) | 0.6 | 0.2 | 1.0 | 0.5 |

## Fig. 10A

Fig. 10B

## Fig. 11A

TE Waves

Loss (dB) vs. $d_1$ (mm), ex1 (Comparative Example)

Loss (dB) vs. $d_1$ (mm), ex2 (Comparative Example)

Loss (dB) vs. $d_1$ (mm), ex3 (Comparative Example)

—— 26.0    ---- 28.0    ---- 29.5

## Fig. 11B

Fig. 12

Fig. 13

Fig. 14A

## Fig. 14B

Perpendicularly Incident Waves (Thickness of Air Layer in IGU = 2×λ/4)

ex1 (Comparative Example)

ex3 (Comparative Example)

ex5 (Example)

ex7 (Example)

Legend: —— 26.0 ----28.0 --·--·29.5

## Fig. 15A

Perpendicularly Incident Waves (Thickness of Air Layer in IGU = 2.5×λ/4)

Legend: —— 26.0    - - - - 28.0    - · - · - 29.5

EP 4 704 249 A1

Fig. 15B

49

## Fig. 16A

## Fig. 16B

TE Waves
(Thickness of Air Layer in IGU = 2×λ/4)

ex1 (Comparative Example)

ex3 (Comparative Example)

ex5 (Example)

ex7 (Example)

—— 26.0    ----- 28.0    ----- 29.5

Fig. 17A

## Fig. 17B

Fig. 18A

## Fig. 18B

Fig. 19

Fig. 20

Fig. 21

Fig. 22

Fig. 23

Fig. 24

Fig. 25

Fig. 26

| | n3 | n2 | Actual Thickness (mm) | |
|---|---|---|---|---|
| | Matching Layer | Intermediate Layer | Matching Layer | Intermediate Layer |
| ex9 (Comparative Example) | 0.0 | 0.0 | 0.0 | 0.0 |
| ex10 (Comparative Example) | 0.5 | 0.0 | 5.0 | 0.0 |
| ex11 (Comparative Example) | 1.0 | 0.5 | 10.0 | 8.3 |
| ex12 (Comparative Example) | 1.5 | 0.0 | 15.1 | 0.0 |
| ex13 (Example) | 1.0 | 0.0 | 10.0 | 0.0 |
| ex14 (Example) | 1.0 | 0.1 | 10.0 | 1.7 |
| ex15 (Example) | 0.8 | 0.1 | 8.1 | 1.9 |
| ex16 (Example) | 0.6 | 0.2 | 6.0 | 3.3 |

Fig. 27A

Fig. 27B

Fig. 28A

Fig. 28B

Fig. 29

Fig. 30

## INTERNATIONAL SEARCH REPORT

| International application No. |
| --- |
| **PCT/JP2024/015382** |

**A. CLASSIFICATION OF SUBJECT MATTER**

*H01Q 1/22*(2006.01)i; *B32B 7/025*(2019.01)i; *B32B 17/00*(2006.01)i; *H05K 3/00*(2006.01)i
FI:  H01Q1/22 Z; B32B7/025; B32B17/00; H05K3/00 D

According to International Patent Classification (IPC) or to both national classification and IPC

**B. FIELDS SEARCHED**

Minimum documentation searched (classification system followed by classification symbols)

H01Q1/22; B32B7/025; B32B17/00; H05K3/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2005-033475 A (TOKAI RIKA CO., LTD.) 03 February 2005 (2005-02-03) | 1-17 |
| A | WO 2019/177144 A1 (AGC INC.) 19 September 2019 (2019-09-19) | 1-17 |
| A | JP 06-196915 A (TAKENAKA CORPORATION) 15 July 1994 (1994-07-15) | 1-17 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **01 July 2024** | **09 July 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/015382**

| Patent document cited in search report | | | Publication date (day/month/year) | Patent family member(s) | | | Publication date (day/month/year) |
|---|---|---|---|---|---|---|---|
| JP | 2005-033475 | A | 03 February 2005 | (Family: none) | | | |
| WO | 2019/177144 | A1 | 19 September 2019 | US | 2021/0005951 | A1 | |
| | | | | EP | 3767745 | A1 | |
| | | | | CN | 112055915 | A | |
| | | | | KR | 10-2021-0018786 | A | |
| JP | 06-196915 | A | 15 July 1994 | GB | 2272579 | A | |
| | | | | DE | 4337108 | A1 | |
| | | | | FR | 2698727 | A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H6196915 A
- JP 2023074385 A